# EUROPÄISCHE PATENTSCHRIFT

(11) **EP 0 709 932 B1**
(45) Veröffentlichungstag und Bekanntmachung des Hinweises auf die Patenterteilung: **22.12.1999**
(21) Anmeldenummer: 95113729.8
(22) Anmeldetag: 11.10.1995
(51) Int. Cl.: H01R 9/26, H01R 25/00, H02B 1/052

(54) **Modulare Steuerungsanlage mit Busleiter z. B. zur Gebäudeautomatisierung**
Modular control installation with bus, e.g. for automation of buildings
Installation de réglage avec bus, par example pour l'automation d'édifice

(30) Priorität: 31.10.1994 DE 4438804
(43) Veröffentlichungstag der Anmeldung: 01.05.1996
(73) Patentinhaber: Weidmüller Interface GmbH & Co., D-32760 Detmold (DE)
(72) Erfinder: Eggert, Gerhard, D-32760 Detmold (DE); Hanning, Walter, D-32758 Detmold (DE); Fiene, Uwe, D-32839 Steinheim (DE); Schnatwinkel, Michael, D-32051 Herford (DE); Steinmeier, Rudolf, D-32760 Detmold (DE); Wilmes, Manfred, D-32760 Detmold (DE)
(74) Vertreter: Stracke, Alexander, Dipl.-Ing.

(56) Entgegenhaltungen:
- DE-A- 4 303 717

## Beschreibung

Die Erfindung betrifft eine modulare Steuerungsanlage für elektronische Steuerungssystem zur Gebäudeautomatisierung gemäß Oberbegriff des Anspruchs 1.

Die Aufgabenstellung einer Steuerungsanlage für elektronische Steuerungssysteme zur Gebäudeautomatisierung besteht darin, die Steuerungseinheit für alle Funktionen innerhalb eines Gebäudes mit in dem Gebäude verteilt installierten Initiatoren, Aktoren, Feldgeräten oder dergleichen elektrisch zu verbinden. Bisher erfolgte die elektrotechnische Installation so, daß jeder einzelne Initiator/Aktor/Feldgerät über eine separate Signalleitung mit in einem zentralen Schaltschrank installierten Eingabe-/ Ausgabekarten der Steuerungseinheit direkt zu verbinden war, wobei teilweise an verschiedenen Stellen innerhalb des Gebäudes Unterverteilungen in Form von Klemmenkästen installiert wurden. Die Aufgabe dieser Klemmenkästen besteht dabei darin, die vielen im Gebäude verteilten Initiatoren/ Aktoren/Feldgeräte zum Transport der Signale in den zentralen Schaltschrank zusammenzuführen. Von jedem Klemmenkasten aus werden die Kabel über Steckverbinder und eine große Anzahl von Steuerkabeln zum zentralen Schaltschrank der Steuerung verlegt. Hier werden wiederum die einzelnen Leitungen auf die zugehörigen Eingabe-/Ausgabekarten der Steuerung verteilt, so daß jedes ein Signal führende Kabel insgesamt über eine Vielzahl von Verbindungspunkten geführt werden muß. Diese Art der Verdrahtung ist gleichzeitig material- und installationsintensiv, erfordert einen hohen Planungs- und Dokumentationsaufwand und ist entsprechend fehlerträchtig.

Es sind weiterhin Steuerungsanlagen der gattungsgemäßen Art bekannt, die dezentral im Bereich der Unterverteilungen eines Gebäudes angeordnet sind und für eine Umsetzung der einkommenden Signale der einzelnen Initiatoren/Aktoren/Feldgeräte auf ein gebäudeweites Feldbussystem sorgen. Hierzu ist in der Regel eine räumlich wenig kompakt bauende und vom Funktionsumfang sowie den benötigten Bauelementen weitgehend vorgegebene Anpaßelektronik erforderlich, die eine vorgegebene Anzahl von Eingabe-/Ausgabeanschlußelementen zur Verfügung stellt und diese über die nachgeordnete Elektronik auf ein Feldbussystem umsetzt. Üblicherweise werden Baugruppen gleichartiger Signalschnittstellen als Anschlußblocks in einem Gehäuse angeboten, die 8, 16 oder sogar 32 gleiche Anschlußmöglichkeiten bieten. Vor allem bei gemischter oder nur in geringer bzw. sehr unterschiedlicher Anzahl benötigter Anschlußmöglichkeiten für die vorliegenden Sensoren ist eine Mindestzahl derartiger Baugruppen zu installieren und daher vom Anwender auch zu bezahlen.

Es sind aus der DE 43 03 717 A1 ferner modulare Steuerungsanlagen bekannt, die aus steckbaren Elektronikmodulen und Anschlußmodulen zusammensetzbar sind, wobei die Anschlußmodule Versorgungsleiter- und Signalleiteranschlüsse aufweisen und aus einzelnen Anschlußscheiben zusammengesetzt sind. Dabei sind dem Versorgungsblock einerseits und dem Eingabe-/Ausgabeblock andererseits zugeordnete Anschlußscheiben auch einstückig ausgeführt und einzeln in ein gemeinsames Gehäuse einsetzbar. Weiterhin sind die Versorgungsklemmen und/oder die Eingangs- und Ausgangsklemmen in verschiedenen Anschlußebenen angeordnet. Weiterhin ist ein Elektronikblock lösbar mit dem Anschlußblock verbunden, wobei dieser vorzugsweise auf bzw. in dem Anschlußblock auf- bzw. eingesteckt wird und durch zugeordnete Kontakte zwischen Elektronikblock und Anschlußblock elektrisch und mechanisch verbindbar ist.

Problematisch an dieser vorgestellten Lösung eines modularen Steuerungssystem ist es, daß eine räumliche Trennung zwischen Versorgungsblock einerseits und dem Eingabe-/Ausgabeblock andererseits erfolgt. Weiterhin ist es bei dieser Lösung erforderlich, die Versorgungsklemmen mit werksseitig fest installierten oder vom Anwender aufwendig nachrüstbaren Einlegebrücken zu versehen, um das zu einem Block oder einem Teil des Blockes gehörige elektrische Potential zwischen den einzelnen Scheiben des Versorgungs- bzw. Anschlußblockes zu verteilen. Darüber hinaus ist es nicht einfach möglich Initiatoren/ Aktoren/Feldgeräte gleicher Signalform, aber unterschiedlicher elektrischer Versorgungswerte an einem gemeinsamen Anschlußblock zu betreiben, da nur an festgelegten Punkten einspeisbare, quer verteilte Versorgungsspannungen an zugehörigen Teilen des Anschlußblocks abzugreifen ist. Durch die Einbettung der einzelnen Anschlußscheiben in ein den gesamten Block umgreifendes Gehäuse ist eine Wartung nur nach Ausbau des gesamten Blockes durch aufwendiges Zerlegen des Anschlußblockes möglich. Es sind darüber hinaus Rangierplatinen innerhalb des Gehäuses des Anschlußblockes vorzusehen, um eine unterschiedliche Logik des Eingabe-/Ausgabeblockes zu erreichen. Dies erfordert wiederum einen Eingriff in die in dem Gehäuse angeordnete Elektronik.

Eine wichtige Vorraussetzung für die Kompatibilität einer an einen Feldbus anschließbaren Lösung mit bestehenden Installationssystemen schon bestehender Gebäude ist es, daß derartige busorientierte Systeme in handelsübliche Unterverteilungskästen, wie sie beispielsweise für Sicherungskästen gebräuchlich sind, eingepaßt werden können, ohne aufwendige Umbauten der Anschlußbauteile hervorzurufen. Dieses Kriterium ist in der vorgeschlagenen Bauform ebenfalls nicht erfüllt, daher ist ein Einsatz innerhalb bestehender Installationen nur sehr schwierig zu realisieren.

Aufgabe der vorliegenden Erfindung ist es daher, eine Steuerungsanlage zur Busankopplung einer Vielzahl vorsehbarer Initiatoren, Aktoren, Feldgeräten oder dergleichen in einem Gebäude an Feldbusanschlußsysteme zu schaffen, die einen Anschluß an kompakt bauende, modular gestaltete Anschlußblocks bei weitgehender Anpaßbarkeit der Anschlußbaugruppen an die zu lösende Aufgabe der Signalbe- und -verarbeitung des Anwenders, möglichst unter Verwendung vertrauter Installationsweisen bei gleichzeitig einfacher Wartung und Wartbarkeit auch einzelner Zweige der Anschlußbaugruppen gewährleistet und klar gegliederte Verdrahtungsbereiche sowie eine übersichtliche Kabelführung erlaubt, wobei auch in besonderem Maße auf die Kompatibilität zu bestehenden Hausinstallationssystemen auch bestehender Gebäude hinsichtlich der Anschlußmaße und Einbauräume Rücksicht genommen werden soll.

Die Lösung der erfindungsgemäßen Aufgabe ergibt sich aus den kennzeichnenden Merkmalen des Anspruchs 1.

Erfindungswesentlich für die vorgeschlagene modulare Steuerungsanlage ist es, daß ein strukturierter Aufbau sowohl einer einzelnen Anschlußscheibe aus vorgegebenen Funktionsbereichen in einer festen räumlichen Aufeinanderfolge vorgeschlagen wird, als auch, daß innerhalb jedes Anschlußblocks die funktionsverschiedenen Anschlußscheiben zwar grundsätzlich beliebig, aber immer in einer vorgebbaren festen Reihenfolge angeordnet sind. Dabei orientiert sich die für das modulare Steuerungssystem ausgewählte Reihenfolge der Anordnung der Anschlußscheiben auf der Tragschiene und die Anordnung der Funktionsbereiche innerhalb jeder Anschlußscheibe vornehmlich an den Bedürfnissen des Anwenders hinsichtlich eines gut zugänglichen Verdrahtungsbereiches und einer Trennung der Funktionen bezüglich der Anbindung an die Initiatoren/Aktoren/ Feldgeräte od. dgl. an das Bussystem sowie bezüglich vorgegebener Einbauräume auch in bestehenden Gebäuden schon installierter Schaltanlagen.

Quer zur Erstreckung der die zu einem Anschlußblock aneinandergereihten Anschlußscheiben tragenden Tragschiene wird jede Anschlußscheibe, wenn es von ihrer Funktion her erforderlich ist, in folgender räumlicher Aufeinanderfolge mindestens je einen der folgenden Bereiche innerhalb jeder Anschlußscheibe aufweisen. Ein erster Bereich ist zur Verteilung benötigter elektrischer Potentiale an weitere Anschlußscheiben des selben Anschlußblockes vorgesehen, an die ebenfalls die zugeordneten Initiatoren, Aktoren, Feldgeräte od. dgl. direkt anschließbar sind. In einem zweiten, dem Verteilungs- und Anschlußbereich räumlich aufeinanderfolgenden Bereich wird vorzugsweise je einer der den zugeordneten Initiatoren, Aktoren, Feldgeräten od. dgl. zugeordneten Signalleiter angeschlossen.

Das Signal auf dem anschließbaren Signalleiter wird mittels einer in die Anschlußscheibe integrierten Kontaktierung zu einem dritten, wiederum dem Signalleiterbereich nachgeordneten Bereich zur lösbaren Anordnung des Elektronikmodules weitergeleitet. Dieser Bereich zur lösbaren Anordnung des Elektronikmodules dient dazu, die elektrisch anliegenden Signale umzusetzen auf den internen Busleiter, der innerhalb eines der Tragschiene zugeordneten Bereiches alle Anschlußblocks miteinander und diese ebenfalls mit dem zugeordneten Feldbus verbindet. Der Elektronikmodul stellt dabei unter Bereitstellung aller benötigten Funktionen zur Signalbe- und -verarbeitung die Koppelungsfunktion zwischen den mit den Signalleiteranschlüssen verbundenen Steckanschlüssen und dem diesen räumlich benachbarten Bussystem her. Der Bereich zur lösbaren Anordnung des Elektronikmodules ist bevorzugt quer zur Anordnung der Tragschiene über dieser Tragschiene und symmetrisch zu den Außenkanten des Anschlußblockes angeordnet, wobei die Gehäusemaße des Elektronikmodules zu den in der Installationstechnik der Gebäudeautomatisierung häufig benutzten Kleinverteileranlagen passend ausgestaltet sind. Somit läßt sich ein erfindungsgemäßes Steuerungssystem für die Gebäudeautomatisierung direkt in schon bestehende Installationen integrieren, der Elektronikmodul bleibt für Wartungs- und Reparaturzwecke innerhalb der Kleinverteilungsanlage direkt zugänglich.

Anschließend an diesen Bereich zur lösbaren Anordnung des Elektronikmodules ist ein zweiter Bereich zum Signalleiteranschluß zugeordneter Initiatoren, Aktoren, Feldgeräte od. dgl. vorgesehen. Dieser zweite Bereich zum Signalleiteranschluß ist grundsätzlich mit dem ersten Bereich zum Signalleiteranschluß funktionsidentisch, er ist wiederum an den Elektronikmodul elektrisch anbindbar, so daß hier anliegende Signale an den Elektronikmodul weitergeleitet werden.

Anschließend an diesen zweiten Bereich zum Signalleiteranschluß ist ein zweiter Bereich zur Verteilung benötigter elektrischer Potentiale an die anderen Anschlußscheiben des selben Anschlußblocks vorgesehen, an die ebenfalls zugeordnete Initiatoren, Aktoren, Feldgeräte od. dgl. direkt anschließbar sind. Dieser zweite Bereich zur Verteilung elektrischer Potentiale stellt in der Regel weitere, ggf. auch ergänzende elektrische Potentiale zu den elektrischen Potentialen zur Verfügung, die im ersten Verteilungsbereich am entgegengesetzten Ende der Anschlußscheibe anschließbar sind. Somit können innerhalb einer Anschlußscheibe alle Arten von Initiatoren, Aktoren, Feldgeräten od. dgl. angeschlossen werden, sofern eine der benötigten Potentiale entsprechende Anzahl von Verteilungsfunktionen vorgesehen wird.

Durch die Anordnung von Bereichen zur Verteilung benötigter elektrischer Potentiale beidseitig quer zur Tragschiene an jeder Anschlußscheibe ist es ebenfalls möglich, innerhalb einer Anschlußscheibe auf jeder Seite des Elektronikmodules jeweils Initiatoren, Aktoren, Feldgeräte und dgl. anzuschließen. Die Signalankopplung sowie die Ankopplung der Versorgungsleitungen erfolgt für jede Seite getrennt, wobei eine derartige Anordnung bevorzugt auch für die Zusammenfassung, beispielsweise von digitalen Ein- und Ausgängen auf je einer Seite eines Anschlußblockes ermöglicht wird. Dies erlaubt eine weitere Verringerung der benötigten Baugruppengröße eines derartigen Anschlußblockes und trägt daher den üblicherweise beengten Platzverhältnissen innerhalb von Kleinverteilungsanlagen Rechnung.

Das erfinderungsgemäße Steuerungssystem weist somit einen symmetrischen Aufbau quer zur Tragschiene auf, wobei der Elektronikmodul zentral über der Tragschiene sitzt und jede Anschlußscheibe beidseits des Elektronikmodules einen gleichen, vertauschbaren Aufbau besitzt. Hierdurch wird es auch möglich, Anschlußblocks hinsichtlich der anschließbaren Ein- und Ausgänge so innerhalb z.B. einer Kleinverteilung anzuordnen, daß eine übersichtliche Kabelführung erreicht wird.

Dieser strukturierten Aufeinanderfolge von Funktionsbereichen innerhalb einer Anschlußscheibe entspricht die vorgebbare Anordnung der Anschlußscheiben innerhalb eines Anschlußblocks. Jeder Anschlußblock setzt sich vorzugsweise zusammen aus einer Reihung, die an einem Ende mit mindestens einer Schutzleiterscheibe beginnt, vorzugsweise fortgesetzt wird mit mindestens einer Einspeisescheibe sowie mindestens einer, vorzugsweise an die Einspeisescheibe anschließend angeordneten Versorgungs-/ Signalleiterscheibe. Üblicherweise werden die Anschlußblocks aus einer modulmäßig zusammengesetzten Anzahl von Anschlußscheiben gebildet, wobei sich zur jeweils vorzugsweise einen Schutzleiterscheibe und Einspeisescheibe die dazu notwendige Anzahl von Versorgungs-/Signalleiterscheiben ergibt. Schutzleiterscheibe und Einspeisungsscheibe können über den Verteilungsbereich mit den Versorgungs-/Signalleiterscheiben verbunden werden und den dort angeschlossenen zugeordneten Initiatoren, Aktoren, Feldgeräten oder dgl. die benötigten Versorgungsspannungen und/oder den Schutzleiteranschluß zur Verfügung stellen. Abschlißend kann in einer weiteren bevorzugten Ausführungsform als Abschluß eines Anschlußblockes mindestens eine Ratsfußscheibe angeordnet sein.

Besonders vorteilhaft an der bevorzugten räumlichen Aufeinanderfolge der Anschlußscheiben innerhalb eines Anschlußblocks bzw. der Funktionsbereiche innerhalb einer Anschlußscheibe ist es, daß sich für den Anwender eine klare, in jedem Anschlußblock wiederholbare Reihenfolge der Funktionselemente ergibt, und die für die Installation der Initiatoren, Aktoren, Feldgeräte od. dgl. wichtigen Versorgungs-/Signalleiterbereiche eine gute Zugänglichkeit innerhalb jeweils zusammenhängender Installationsbereiche erlaubt. Die Verteilung der auch unterschiedlichen Potentiale der Versorgungsspannungen und -ströme innerhalb des Anschlußblocks wird sehr flexibel auch kabellos durch vorgefertigte Bauelemente gelöst, an die wiederum direkt die Kabel der Initiatoren/Aktoren/Feldgeräte anschließbar sind. Hiermit wird die dem Anwender von der bekannten Technik der Reihenklemme vertraute Vorgehensweise auf die Möglichkeiten der Anbindung an ein Bussystem übertragen, wodurch vor allen Dingen auch aufgrund der klar gegliederten Verdrahtungsbereiche eine übersichtliche Kabelführung erzielbar ist. Der modulare, aus Anschlußscheiben bestehende Aufbau eines Anschlußblockes erlaubt es weiterhin, während der Installation zu Testzwecken und auch bei später eventuell notwendigen Fehlersuchen und Wartungen direkt auf einzelne Zweige und Bereiche der Anschlußbaugruppen zuzugreifen und diese klar voneinander zu trennen.

Der Aufbau der einzelnen Anschlußscheiben aus räumlich aufeinanderfolgenden Funktionsbereichen ermöglicht es weiterhin, für jede der funktionsverschiedenen Anschlußscheiben nur diejenigen Bereiche elektrotechnisch zu bestücken, die tatsächlich für die jeweilige Funktion benötigt werden. Hierdurch ist es möglich, mit nur wenigen Anschlußscheibenbauformen bzw. gleichen Bauformen der Anschlußscheiben bei unterschiedlicher Bestückung sehr viele verschiedene, für die Steuerungsanlage benötigte Einzelfunktionen zu realisieren. Ebenfalls von großem Vorteil, vor allem auch im Bezug auf eine problemlose Wartung und den Austausch defekter Komponenten ist es, daß der Elektronikbereich zur Be- und Verarbeitung der Signale zentral innerhalb des lösbar und steckbar ausgeführten Elektronikmodules zusammengefaßt ist, wodurch ein schneller Austausch einer derartigen Einheit bzw. auch die Anpassung der Funktionen jedes Elektronikmoduls an die Funktionalität jeder Anschlußbaugruppe möglich ist.

Eine vorteilhafte Ausführungsform einer Schutzleiterscheibe weist einen mechanischen und elektrischen Anschluß zur Tragschiene und einen Steckanschluß zum Elektronikmodul auf. Die Schutzleiterscheibe kann weiterhin in vorteilhafter Weise mit der Potentialverteilung an weitere Anschlußscheiben des selben Anschlußblocks verbindbar sein, wobei jeder der beiden Verteilungsbereich anschließbar ist.

An der Einspeisescheibe sind die Versorgungsspannungen sowohl für die Verteilung an die Initiatoren, Aktoren, Feldgeräte od. dgl. des Anschlußblockes als auch des Elektronikmoduls anschließbar. Bei Bauformen der erfindungsgemäßen Anschlußscheiben mit mindestens je einer Vorrichtung zur Aufnahme von Verteilerleisten beidseits des Elektronikmodules ist es sinnvoll, die Einspeisung der zugehörigen elektrischen Potentiale für jede Seite getrennt vorzunehmen und dafür an jeder Seite mindestens eine als zweite Scheibe von beiden Enden des Anschlußblockes angeordnete Einspeisescheibe vorzusehen. Bei der Einspeisung von elektrischen Potentialen für jede Seite der Anschlußscheibe bezüglich des Elektronikmodules reicht es in der Regel aus, die der Querverteilung zugeordnete Hälfte der Anschlußscheibe für die Einspeisefunktion zu belegen. Die gegenüberliegende, nicht für die Einspeisung benötigte Seite kann zur weiteren Reduzierung des Platzbedarfes mit normaler Versorgungs-/Signalleiterfunktion ausgebildet werden, so daß auch hier weitere Initiatoren, Aktoren, Feldgeräte oder dgl. anschließbar sind. Werden bei Bauformen mit Vorrichtungen zur Aufnahme von Verteilerleisten zwei unterschiedliche Potentiale extern in die Verteilerleisten eingespeist, so können hierfür auch zwei nebeneinander angeordnete Einspeisescheiben vorgesehen werden, die in der vorstehend beschriebenen Weise ebenfalls wieder auf der jeweils anderen Seite als Versorgungs/Signalleiterscheibe nutzbar sind. Dann wird jedes der Potentiale von der Einspeiseseite dieser Scheibe auf die jeweilige Verteilerleiste durchkontaktiert und mit Hilfe der Anschlußelemente querverteilt. Auch kann es sinnvoll sein, eine Einspeisescheibe ausschließlich mit dem Elektronikmodul zu verbinden, um Störungen der Elektronik aus dem Leistungsbereich der Steuerung zu vermeiden.

Eine Versorgungs-/Signalleiterscheibe zum Anschluß der zugeordneten Initiatoren, Aktoren, Feldgeräte od. dgl. besteht beidseits des Elektronikmoduls aus je einem Bereich, in dem auch querverteilende Verteilerleisten angeordnet werden können und je einem Bereich mit jeweils einer Signalleiterklemme und den Steckanschlüssen für den Elektronikmodul. In die Vorrichtungen zur Aufnahme von Verteilerleisten werden in diese rastbar angeordnete, auch querverteilende Anschlußelemente eingesteckt, die zu Verteilerleisten aneinander gereiht sind und an denen die Versorgungskabel für die Initiatoren, Aktoren, Feldgeräte od. dgl. angeordnet werden können. Für eine gute Übersichtlichkeit der Verteilung der Potentiale können diese Anschlußelemente in vorteilhafter Weise farbig ausgeführt werden. Zur Verrastung der Anschlußelemente bzw. Verteilerleisten weisen die Vorrichtungen zur Aufnahme von Verteilerleisten Befestigungskonturen auf, die mit entsprechenden Gegenkonturen der Anschlußelemente zusammenwirken.

Bei Bauformen von Anschlußscheiben, die keinen Verteilungsbereich aufweisen, werden in der Regel nur die Signalanschlüsse, üblicherweise getrennt für verschiedene Initiatoren, Aktoren, Feldgeräte oder dgl. auf jeder Seite des Elektronikmodules angeschlossen. Eine typische Bauform hierfür ist es, auf der einen Seite des Elektronikmoduls alle Signalanschlüsse, beispielsweise von digitalen Eingängen, zusammenzufassen und auf der anderen Seite die Anschlüsse mit digitalen Ausgängen zu belegen. Die Versorgung derartiger Initiatoren, Aktoren, Feldgeräte erfolgt dann üblicherweise außerhalb des Anschlußblockes, so daß nur die Signalleitungen des Anschlußblockes genutzt werden.

Zur mechanischen Befestigung jedes Anschlußblockes an der Tragschiene weist jeder Anschlußblock vorzugsweise an den beiden Anschlußscheiben am Anfang und am Ende des Druchtritts der Tragschiene durch den Anschlußblock derart ausgeführte Anschlußscheiben auf, daß jeweils der Tragschiene zugeordnete Rastfüße zur mechanischen Klemmung auf und/oder elektrischen Verbindung mit dieser Tragschiene vorhanden sind. Hierdurch wird der Anschlußblock mechanisch sicher auf der Tragschiene befestigbar und gleichzeitig ein Anschluß an die üblicherweise als Schutzleiter weiter verbundene Tragschiene realisiert. Durch die beidseitige Anordnung von Rastfüße aufweisenden Anschlußscheiben ist es möglich, dazwischen angeordnete Anschlußscheiben auch ohne direkten mechanischen Kontakt mit der Tragschiene zwischen diesen beiden Anschlußscheiben anzureihen.

In einer besonders vorteilhaften Ausführungsform ist es möglich, gleichartige Initiatoren, Aktoren, Feldgeräte od. dgl. nach Bedarf in Anschlußblocks gleichartiger Versorgungs-/ Signalleiter zusammenzufassen oder die Anschlußblocks aus funktionell gemischt aufgebauten Versorgungs-/Signalleiterscheiben zu bilden. Durch diese Reihungsmöglichkeit gleicher oder verschiedenartiger Versorgungs-/Signalleiterscheiben innerhalb eines Anschlußblockes können zum einen für eine übersichtliche Installation Zusammenfassungen funktionell gleicher Sensoren gewählt werden, wobei bei Bedarf jedoch auch nach der lokalen Anordnung der Initiatoren, Aktoren, Feldgeräte od. dgl. gegliederte Anschlußblocks gebildet werden können.

In einer weiteren, besonders vorteilhaften Ausführungsform wird der interne Busleiter, aus Busschienenstücken zusammengesetzt, die über verschiebbare und rastbare Trennschieber lösbar und elektrisch/mechanisch mit den benachbarten Busleiterstücken verbindbar sind. Eine derartige segmentweise Zusammensetzung des Busleiters aus Busschienenstücken ermöglicht es, z. B. bei der Wartung einzelne Anschlußblocks durch Auskoppeln aus dem Busleiter elektrisch und mechanisch vom Busleiter zu trennen und diese dann ggf. separat von der Tragschiene abzurasten. Die Trennschieber sind auf der von der Tragschiene abgewandten Seite verdeckt, solange der Elektronikmodul in seinem Steckplatz befestigt ist. Hierdurch wird verhindert, daß ein Anschlußblock versehentlich abgerastet werden kann, der noch elektrisch mit dem Bussystem verbunden ist.

An einem Ende des Busleiters ist eine Anschlußmodulscheibe zur Ankopplung des der Tragschiene zugeordneten Busleiters an ein zugeordnetes Feldbussystem vorgesehen. An dem dem feldbusseitigen Ende abgewandten Ende des internen Busleiters ist eine steckbare Abschlußplatte mit Widerständen zum elektrischen Abschluß des internen Busleiters vorsehbar ist, die vorzugsweise als Steckschuh mit einer an der internen Busleiterplatine angeordneten Platine ausführbar ist, die wiederum die Abschlußwiderstände zwischen den einzelnen Busleiterbahnen trägt.

Zur Kopplung der Signalleiter mit dem internen Busleiter weist jedes Elektronikmodul mindestens je einen steckbaren und lösbaren Steckanschluß auf der einen Seite mit den den Signalleitern zugeordneten elektrischen Verbindungselementen und zum anderen mit dem internen Busleiter auf, wobei diese Steckanschlüsse über Funktionsleiterplatten miteinander verbunden sind, auf denen die Signalbe- und -verarbeitung stattfindet.

In einer vorteilhaften Ausführungsform ist jedem Anschlußblock mindestens je ein Elektronikmodul zugeordnet, wobei je nach Anwendungsfall auch die Zuordnung von mehr als einem Anschlußblock zu einem Elektronikmodul oder von mehreren Elektronikmodulen je Anschlußblock denkbar ist.

Beim Anschluß aktiver Initiatoren/Aktoren/Feldgeräte oder dgl. muß immer mindestens eine Vorrichtung zur Aufnahme von Verteilerleisten und mindestens je ein Signalleiteranschluß vorgesehen sein, um die auf dem Signalleiter zurückkommenden Signale an den Elektronikmodul weiterleiten zu können.

Der Elektronikmodul weist ein mindestens einer Anschlußscheibe zugeordnetes Gehäuse auf, das codierbar ist.

Von besonderer Vorteilswirkung ist es weiterhin, daß beim Entfernen eines Elektronikmodules von einem oder von mehreren der zugeordneten Anschlußblocks durch den weiterhin verbundenen Busleiter die restlichen an der Tragschiene angeordneten Anschlußblocks voll funktionsfähig bleiben.

Der Anschluß aller Leiter auf der Versorgungs-/Signalleiterseite erfolgt von der der Tragschiene abgewandten Seite, wobei bei vorgenommener Verdrahtung der Elektronikmodul auch ohne Lösen der Verdrahtung in Form einer sogenannten stehenden Verdrahtung abnehmbar ist.

In einer weiteren vorteilhaften Ausführungsform wird zwischen die Signalleiteranschlüsse zum Anschluß der Verkabelung von den Initiatoren, Aktoren, Feldgeräten oder dgl. und dem Elektronikmodul eine mechanische und elektrische Trennung derart vorgenommen, daß Trennstecker vorsehbar sind, die bei Betätigung automatisch den elektrischen Kontakt zu dem Elektronikmodul und Anschlußelementen für die Signalleiter unterbrechen und eine exakte Messung von Teilspannungen und Strömen zulassen. Hierdurch ist eine Lokalisierung von Fehlern besonders einfach möglich.

Die Anbindung des internen Busleiters an einen übergeordneten Feldbus, wobei hier auch unterschiedliche Feldbussysteme zum Einsatz kommen können, erfolgt hinsichtlich der Signalanpassung in einem der Tragschiene zugeordneten Feldbusanschlußmodule, zu dem mittels einer Direktverdrahtung der Feldbuskabel einfach eine Verbindung hergestellt werden kann.

Besonders vorteilhafte Ausführungsformen des erfindungsgemäßen modularen Steuerungssystems zeigt die folgende Zeichnung.

Es zeigen:
- Figur 1: eine Gesamtansicht des modularen Steuerungssystems mit einem Anschlußblock, einem Elektronikmodul und dem Feldbusanschluß,
- Figur 2: eine Darstellung des Gehäuses des Elektronikmoduls mit eingesteckten Funktionsleiterplatten,
- Figur 3: eine Darstellung des modularen Steuerungssystems mit zwei Anschlußblocks sowie daran angeschlossenen Initiatoren, Aktoren, Feldgeräten oder dgl.,
- Figur 4: eine Darstellung von Anschlußblocks gemäß Figur 3 mit Darstellung zweier Anschlußblocks in anderer Bauform ohne Verteilerleisten
- Figur 5: eine Schutzleiterscheibe mit beidseitig je einer Verteilerleiste in der Seitenansicht mit daran angeordnetem Elektronikmodul,
- Figur 6: eine Einspeisescheibe mit beidseitig je einer Verteilerleiste in der Seitenansicht mit daran angeordnetem Elektronikmodul,
- Figur 7: eine Versorgungs-/Signalleiterscheibe mit beidseitig je einer Verteilerleiste in der Seitenansicht mit daran angeordnetem Elektronikmodul,
- Figur 8: eine Rastfußscheibe in der Seitenansicht mit daran angeordnetem Elektronikmodul,
- Figur 9: eine Versorgungs-/Signalleiterscheibe in der Seitenansicht ohne Verteilerleisten und integriertem Signalleiter, einseitig mittels Verteilerkämmen gebrückt,
- Figur 10: eine Schutzleiterscheibe in der Seitenansicht ohne Verteilerleisten mit direktem Anschluß des Schutzleiters an den Elektronikmodul,
- Figur 11: eine Einspeisescheibe in der Seitenansicht mit beidseitig je zwei Verteilerleisten und daran angeordnetem Elektronikmodul,
- Figur 12: eine Versorgungs-/Signalleiterscheibe mit beidseitig je zwei Verteilerleisten in der Seitenansicht mit daran angeordnetem Elektronikmodul,
- Figur 13: eine Schutzleiterscheibe mit beidseitig je zwei Verteilerleisten in der Seitenansicht mit daran angeordnetem Elektronikmodul,
- Figur 14: eine Versorgungs-/Signalleiterscheibe in einer Bauform mit Trennsteckern in der Seitenansicht mit daran angeordnetem Elektronikmodul,
- Figur 15: eine Abschlußscheibe zur Anordnung an dem dem feldbusseitigen Ende des internen Busleiters abgewandten Ende des Busleiters,
- Figur 16: Anordnung von Trennelementen zur Potentialtrennung innerhalb einer Verteilerleiste.

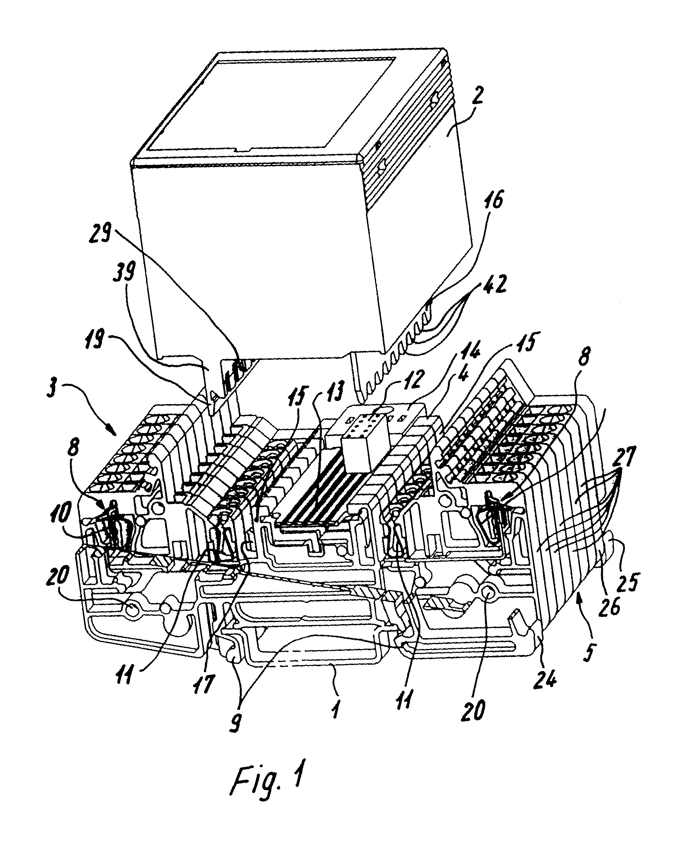

Die Figur 1 zeigt eine Gesamtdarstellung eines erfindungsgemäßen modularen Steuerungssystems, wobei hier ein aus einzelnen Anschlußscheiben 24-27 ein Anschlußblock 3 gebildet ist und auf den Anschlußblock 3 ein Elektronikmodul 2 vertikal aufsteckbar ist.

Der Anschlußblock 3 besteht aus einer Reihung in erfindungsgemäßer Weise einer Schutzleiterscheibe 25, mindestens einer Einspeisescheibe 26, sowie einer Anzahl von Versorgungs-/ Signalleiterscheiben 27 und wird abgeschlossen durch eine Rastfußscheibe 24. Beidseitig außenliegend kann am Anschlußblock 3 in den hier nicht dargestellten Vorrichtungen zur Aufnahme von Verteilerleisten 6 eine Anzahl von zu Verteilerleisten gereihten Anschlußelementen 7 aufgesteckt werden, die elektrische Potentiale, die an der mindestens einen Einspeisescheibe 26 in den Anschlußblock 3 eingespeist werden, zu anderen Versorgungs-/Signalleiterscheiben des gleichen Anschlußblocks 3 querverteilt. Diese Anschlußelemente 7 sind ebenfalls zum Anschluß der Versorgungsleitungen der zugeordneten Initiatoren, Aktoren, Feldgeräte od. dgl. vorsehbar. Hierzu sind die Anschlußelemente 7 mit Verbindungselementen 10 zum hier als Einstecksystem ausgeprägten schraubenlosen Klemmen der Versorgungskabel ausgestattet, wobei die Kabel in einer vertikalen Richtung in die Anschlußelemente 7 eingesteckt werden.

Direkt neben den Vorrichtungen zur Aufnahme von Verteilerleisten 6 ist beidseitig des Elektronikmoduls je ein Signalleiteranschluß 8 angeordnet, der in diesem Fall je einen Signalleiter der jeweils zugeordneten Initiatoren, Aktoren, Feldgeräte od. dgl. anschließbar macht. Diese Signalleiteranschlüsse 8 sind hier ebenfalls mit Verbindungselementen 10 der vorstehenden Art ausgerüstet, so daß auch hier die Signalleiterkabel vertikal von oben in die Signalleiteranschlüsse 8 eingesteckt werden können.

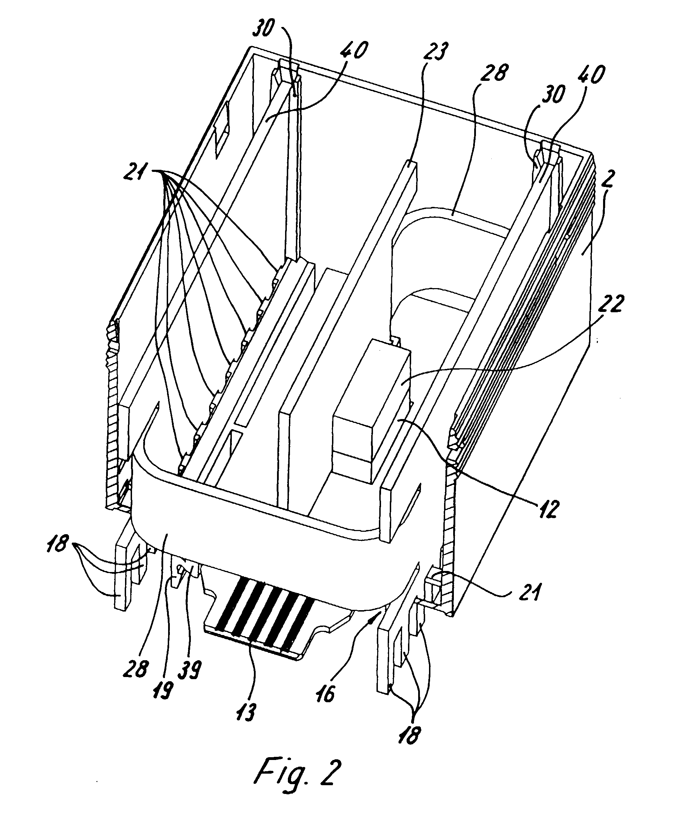

Mittig oberhalb der Tragschiene 1 und des Busleiters 13 ist der Steckplatz für das Elektronikmodul 2 ausgeführt, der aus einer Anzahl von mechanischen Führungs- und Verrastungselementen sowie elektrischen Steckverbindern besteht. Das in der Figur 2 in einer Schnittdarstellung ausführlicher dargestellte Gehäuse des Elektronikmoduls 2 ist im wesentlichen aus rechteckig angeordneten Wandungselementen aufgebaut, wobei Führungs- und Verrastungselemente zur mechanischen Befestigung des Gehäuses an dem Anschlußblock vorgesehen sind.

Innerhalb des vom Gehäuse des Elektronikmodules 2 umschlossenen Bauraumes werden über Steckverbindungen 11 zum Anschluß der Signalleiter 8 an den Elektronikmodul 2 sowie den Steckverbinder 12 zur Verbindung des internen Busleiters 13 mit dem Elektronikmodul 2 alle elektrischen Kontakte hergestellt, die den Anschlußblock 3 mit dem Elektronikmodul 2 verbinden müssen. Der Elektronikmodul 2 ist also durch einfaches vertikales Aufstecken sowohl mit dem Anschlußblock 3 und den an diesen Anschlußblock 3 klemmenseitig anliegenden Signalen und Versorgungsspannungen verbunden als auch mit dem internen Busleiter 13, der die Verbindung einer Reihung von Anschlußblocks 3 mit einem nicht dargestellten Feldbusanschlußmodul 4 herstellt. Die beidseitigen Reihen 11 der Steckanschlüsse zur Verbindung des Elektronikmoduls 3 mit den Signalleitern 8 beinhalten in der Schutzleiterscheibe 25 und der Einspeisescheibe 26 Funktionen zur Versorgung des Elektronikmodules 3 mit benötigten elektrischen Potentialen sowie der Verbindung mit dem Schutzleiter. Hierzu werden die jeweiligen Anschlußscheiben 24,25,26 in der benötigten Weise elektrisch mit anderen Bestandteilen des Anschlußblockes 3 verbunden. Innerhalb der Versorgungs-/Signalleiterscheibe sind die Signalleitersteckanschlüsse 11 mit den Signalleiteranschlüssen 8 elektrisch leitend verbunden, so daß die über die Signalkabel einlaufenden Signale auch an den Steckanschlüssen 11 anliegen. In die Steckanschlüsse 11 werden innerhalb des Gehäuses des Elektronikmodules 2 angeordnete, hierfür vorbereitete Funktionsleiterplatten 40 eingesteckt, so daß auf den Funktionsleiterplatten 40 angeordnete Kontakte mit den Steckanschlüssen 11 eine elektrische Verbindung herstellen. Ein weiterer Steckanschluß 12 besteht innerhalb des Gehäuses des Elektronikmodules 2 mit dem Busleiter 13, vorzugsweise in Form eines Platinensteckverbinders 12, der hier alle benötigten Verbindungen innerhalb eines Steckerblockes bereitstellt. Von diesem Platinensteckverbinder 12 werden die Kontakte auf die Leiterbahnen des internen Busleiters 13 verteilt und von dort auf ein Feldbusanschlußmodul 4 bzw. weitere Busleiterbereiche 13 an einer Tragschiene 1 weitergeleitet.

In Verlängerung der Tragschiene 1 ist hinter dem Anschlußblock 3 ein Feldbusanschlußmodul 4 angeordnet, das wiederum scheibenförmig aufgebaut ist und neben der Anschaltelektronik für den Feldbus auch Anschlußelemente 22 zur elektrischen Versorgung des Feldbusanschlußmodules 4 beinhaltet. Innerhalb des Feldbusanschlußmodules 4 werden die Signale des internen Busleiters 13 so be- bzw. verarbeitet, daß beispielsweise an mehreren Tragschienen 1 angeordnete Anschlußblocks 3 miteinander verbindbar sind oder Signale an eine übergeordnete Auswertestelle weitergemeldet werden.

Der Anschlußblock 3 wird gebildet aus der schon genannten Anzahl von Anschlußscheiben 24 bis 27, wobei die Anschlußscheiben des Anschlußblockes 3 durch Reihung mittels formschlüssiger Elemente 20, hier vorzugsweise als Steckbolzen und -bohrung ausgeführt, gegeneinander gesichert sind. Die Befestigung des Anschlußblockes 3 an der Tragschiene 1 erfolgt mittels Rastfüßen 9, die zum einen in der Schutzleiterscheibe 25, zum anderen auf der Rastfußscheibe 24 angeordnet sind und mit denen die Rastfüße 9 auf der Tragschiene 1 geklemmt werden. Das Einrasten erfolgt in bekannter Weise durch Einhängen einer Seite des Anschlußblockes 3 an der Tragschiene 1 und dem Verrasten durch Niederdrücken in vertikaler Richtung, wobei ein beweglicher Rastfuß 9 federnd zurückweicht und im eingerasteten Zustand die Tragschiene 1 hintergreift.

Zum Abrasten eines Anschlußblockes 3 wird nach dem Abnehmen des Elektronikmoduls 2 und dem Auftrennen des aus Busleiterstücken zusammengesetzten Busleiters 13 mittels Trennschiebern 14 mit einem geeigneten Werkzeug unter den Anschlußblock 3 gefaßt und dieser nach oben abgehebelt. Durch die formschlüssigen Ratszapfenverbindungen 20 zwischen den einzelnen Anschlußscheiben 24-27 werden alle zwischen der Rastfußscheibe 24 und der Schutzleiterscheibe 25 frei angeordneten Versorgungs-/Signalleiterscheiben 27 und Einspeisescheiben 26 sicher gehalten.

Zur Anordnung des Elektronikmodules 2 an dem Anschlußblock 3 sind an der Unterseite des Gehäuses des Elektronikmodules 2 Führungs- und Verrastungselemente vorgesehen, die zum einen aus einer Führungslasche 16 mit daran unterseitig angeordneten Formelementen 42 gebildet sind, die in der Figur 1 auf der rechten Seite des Gehäuses des Elektronikmodules 2 vorgesehen sind. Zum anderen ist auf der gegenüberliegenden Seite eine Einrastleiste 39 vorgesehen, die zum einen unterseitig ein durchlaufendes Verrastungselement 19 trägt, das mit auf allen Anschlußscheiben angeordneten Rasthaken 17 zusammenwirkt und eine vertikale Verrastung des Elektronikmodules bewirkt. Zum anderen ist an der Einrastleiste 39 eine Anzahl von Codierungselementen vorgesehen, die veränderbar bestückbar sind und eine eindeutige Zuordnung von Elektronikmodul 2 zu den jeweiligen Anschlußblocks 3 ermöglichen. Einrastleiste 39 und Führungslasche 16 sind parallel zur Erstreckung der Tragschiene angeordnet und greifen in entsprechende Vertiefungen der Anschlußscheiben ein, die durch die Anreihung der Anschlußscheiben kanalartig ausgebildet sind. Sowohl Einrastleiste 39 als auch Führungslasche 16 sind innenliegend zu den Steckanschlüssen 11 für die Signalleiter angeordnet, in die n der Figur 1 nicht dargestellte Funktionsleiterplatten bei der Fügebewegung des Elektronikmodules 2 automatisch eingesteckt werden. Hierzu treten die in der Figur 1 nicht dargestellten Funktionsleiterplatten unterseitig des Gehäuses des Elektronikmodules 2 mittels dafür vorgesehener Kontaktierungsstege aus dem Gehäuse aus, so daß die Kontaktierungsstege in die Steckanschlüsse 11 eingesteckbar sind.

In der Figur 2 ist in einer Darstellung das Innere des Gehäuses des Elektronikmodules 2 dargestellt. Zur besseren Übersichtlichkeit bei der Darstellung des Aufbaus des Elektronikmodules 2 sind auf der vorderen Seite der Zeichnung die Seitenwände sowie der oberseitig liegende Deckel entfernt.

Beidseitig der Seitenwände des Gehäuses des Elektronikmodules 2 sind zwei Funktionsleiterplatten 40 in Führungsschienen 30 eingesteckt und miteinander über einen Verbindungssteg 28, der im vorderen Bereich des Elektronikmodulgehäuses 2 angeordnet ist, elektrisch miteinander verbunden. Ebenfalls besteht eine elektrische Verbindung der beiden Funktionsleiterplatten 40 mittels eines Verbindungssteges 28 zu einer zentralen Funktionsleiterplatte 23, die mittig in dem Gehäuse des Elektronikmodules 2 direkt oberhalb des Busleiterbereiches 13 angeordnet ist und die die elektrische Ankopplung der einkommenden Signale auf den Busleiter 13 übernimmt. Hierzu werden über die beiden Steckverbinder 12 und 22 elektrische Verbindungen zwischen dem Elektronikmodul 2 und dem Busleiter 13 derart hergestellt, daß der Steckverbinder 12, der auf dem Busleiter 13 angeordnet ist, mit entsprechenden Gegenkontakten des Steckverbinders 22 zusammenwirkt, der auf der Seite des Elektronikmodules 2 angeordnet ist. Es besteht also zwischen den Funktionsleiterplatten 40, der zentralen Funktionsleiterplatte 23 und dem Busleiterbereich 13 über die Steckverbinder 12 und 22 eine elektrisch leitende Verbindung. Die Be- und Verarbeitung der Signale, die an den Elektronikmodul 2 weitergeleitet werden, erfolgt dabei auf den Funktionsleiterplatten 40 und 23.

Die Einleitung der elektrischen Signale, die auf den Signalleiteranschlüssen 8 des Anschlußblockes anstehen, erfolgt mittels Einstecken des Elektronikmodules 2 in die Steckanschlüsse 11, wozu hier an der Unterseite der Funktionsleiterplatten 40 zu den Steckanschlüssen 11 passende Kontaktierungsleisten 18 angeordnet sind, auf denen Leiterbahnen den elektrischen Kontakt zwischen einerseits den Steckanschlüssen 11 und den Kontaktierungsleisten 18 mit entsprechenden Funktionsbaugruppen der Funktionsleiterplatten 23 und 40 weiterleiten. Die Kontaktierungsleiste 18 ist entsprechend der Teilung der Steckanschlüsse 11 in einzelne Vorsprünge unterteilt, die zinkenförmig aus dem Gehäuse des Elektronikmodules 2 unterseitig hervorstehen und mit den Steckanschlüssen 11 in elektrische Verbindung treten. Zur Begrenzung der Einsteckbewegung bei der Montage der Funktionsleiterplatten 40 sind zwischen den Zinken der Kontaktierungsstege 18 Stege 21 vorgesehen, die gehäuseseitig zwischen den Zinken angeordnet sind und eine exakte Höheneinstellung der Funktionsleiterplatte 40 ermöglichen. Jeweils innenliegend von den Kontaktierungsleisten 18 sind die schon vorstehend erwähnten Führungslasche 16 sowie die Einrastleiste 39 angeordnet. Die Führungslasche 16 ist in der Darstellung der Figur 2 nicht zu erkennen und nur als Bezugszeichen aufgeführt. Hingegen erkennt man die Einrastleiste 39 mit den unterseitig angeordneten Verrastungselementen 19.

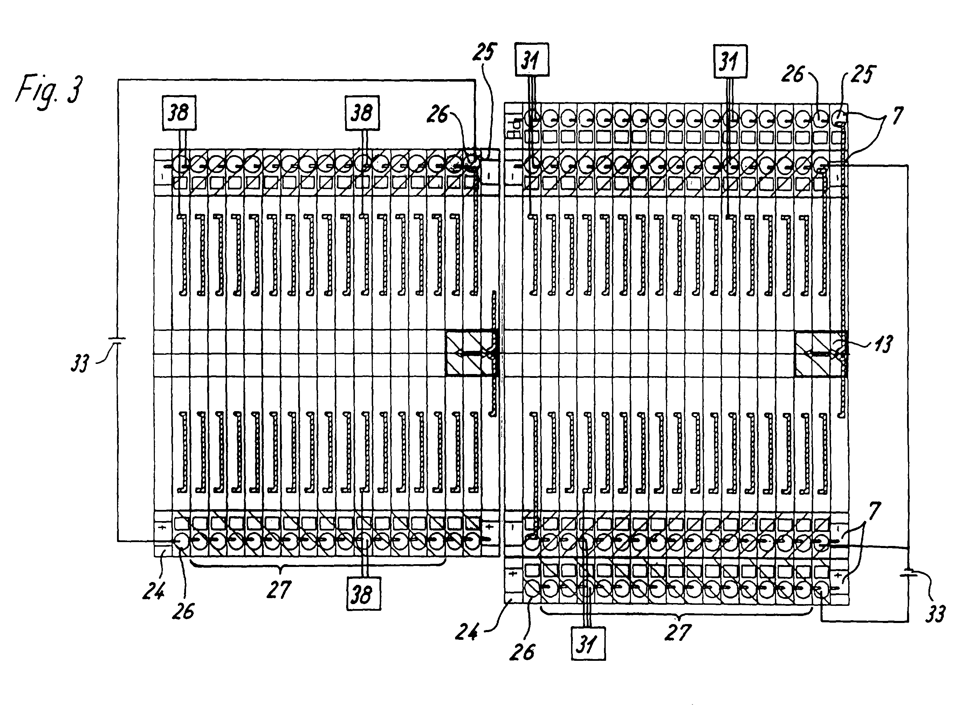

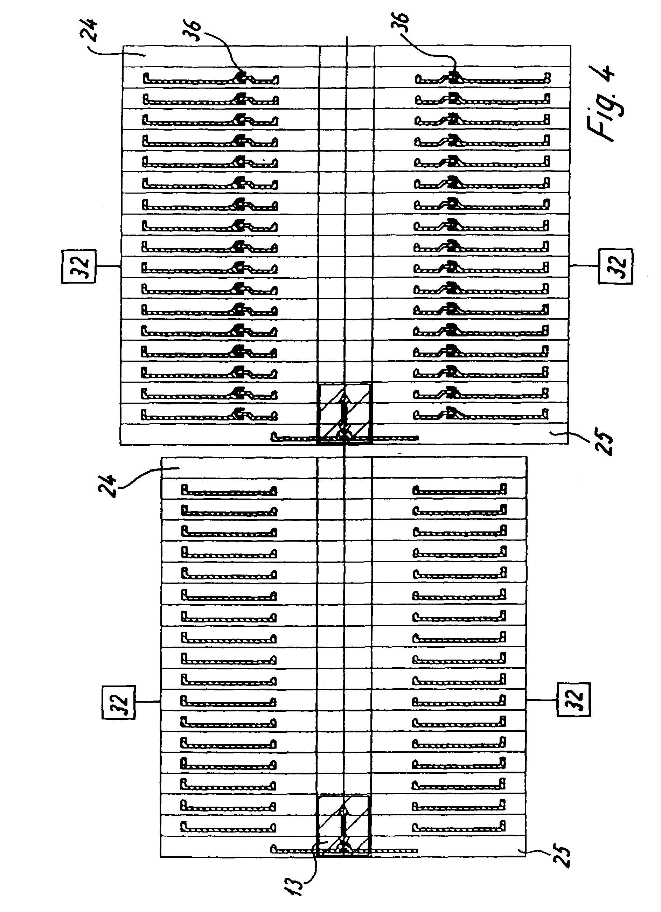

In den Figuren 3 und 4 sind typische Verschaltungsanordnungen von Anschlußblocks 3 zur Verbindung von Initiatoren, Aktoren, Feldgeräten oder dergleichen mit dem internen Busleiter 13 aufgezeigt. Jeder der beiden Anschlußblocks 3 besteht in erfindungsgemäßer Weise aus einer Reihung einer Schutzleiterscheibe 25, mindestens einer Einspeisescheibe 26, einer Anzahl von Versorgungs-/Signalleiterscheiben 27 sowie einer Rastfußscheibe 24, wobei die beiden Anschlußblocks 3 ebenfalls in direkter Reihung aneinander anschließen, so daß die Rastfußscheibe 24 des ersten Anschlußblockes 3 direkt an der Schutzleiterscheibe 25 des zweiten Anschlußblockes 3 anliegt.

Jeder der Anschlußblocks 3 in der Figur 3 weist beidseitig eine gleiche Anzahl von Verteilerleisten aus Anschlußelementen 7 auf, mit denen jeweils für eine Seite benötigte elektrische Potentiale innerhalb des Anschlußblockes 3 querverteilt werden. die Spannungsversorgung der Verteilerleisten erfolgt über externe Spannungsversorgungen 33, die zwischen den jeweiligen Einspeiseklemmen 26 ein benötigtes elektrisches Potential zur Verfügung stellen. Die Einleitung in die Einspeiseklemmen 26 erfolgt dabei nur in eine Hälfte der Einspeiseklemme 26, so daß die gegenüberliegende Hälfte jenseits des Elektronikmodules 2 für die Anbindung von Signalleitungen und Versorgungsleitungen weiterer Initiatoren, Aktoren, Feldgeräte oder dergl. zur Verfügung steht. Dies ist beispielsweise in dem Anschlußblock 3 mit einer Verteilerleiste zu erkennen, da gegenüberliegend der Einspeisung in der linken Einspeiseklemme 26 ebenfalls ein hier beispielsweise als Aktor mit einer Signalleitung ausgeführter Aktor 38 angeschlossen ist. In entsprechender Weise werden auf allen Versorgungs-/Signalleiterscheiben 27 Initiatoren, Aktoren, Feldgeräte oder dergleichen mit der entsprechenden Anschlußkonfiguration angeschlossen, die die jeweils auf der Anschlußseite vorliegenden elektrischen Potentiale benötigen. Es ist hierdurch möglich, die Anschlüsse an die Anschlußscheiben 24-27 des Anschlußblockes 3 so auszulegen, daß auf einer Seite des Anschlußblockes 3 beispielsweise eine Anzahl von Eingängen, auf der gegenüberliegenden Seite eine Anzahl von Ausgängen anschließbar sind. Damit wird eine weitere Reduzierung des benötigten Bauraumes erreicht, die für den geringen, in Kleinverteilungsanlagen zur Verfügung stehenden Raum eine verbesserte Anwendbarkeit des erfindungsgemäßen Steuerungssystems bedeutet.

Der rechte Anschlußblock 3 der Figur 3 ist mit jeweils 2 Verteilerleisten 7 pro Anschlußseite des Anschlußblockes 3 ausgestaltet, der einen Anschluß von Initiatoren, Aktoren, Feldgeräten oder dgl. in Dreileitertechnik ermöglicht. Hierzu werden die Sensoren 31 auf der einen Seite an das positive und negative Potential sowie die Signalleitung angeschlossen, auf der anderen Seite könnte beispielsweise ein derartiger Sensor 31 an das negative Potential, den Schutzleiter und den Sensoreingang angeschlossen werden. Ebenfalls ist es hier wiederum möglich, nicht benötigte Hälften einer Einspeisescheibe 26 mit Versorgungs-/Signalleiterfunktion zu bestücken und dementsprechend einzusetzen.

In der Figur 4 sind Ausführungsformen des erfindungsgemäßen Steuerungssystem dargestellt, bei denen keine Querverteilung von elektrischen Potentialen mittels Verteilerleisten vorgesehen ist. An derartige Anschlußblocks können beispielsweise einfache digitale Sensoren derart angeschlossen werden, daß lediglich die Signalleitungen beispielsweise passiver Sensoren 32 auf die entsprechenden Anschlußklemmen einer Anschlußscheibe 27 beidseitig, getrennt voneinander aufgelegt werden, so daß in einem derartigen Anschlußblock eine gleich große Anzahl von z.B. Eingängen und Ausgängen zur Verfügung steht. Die Versorgung derartiger Sensoren 32 kann dann extern über entsprechende Potentialverteilungen erfolgen, wobei auch hierbei üblicherweise von einer Potentialvervielfachung Gebrauch gemacht wird. Der rechte Anschlußblock der Figur 4 weist als weitere Besonderheit Trennstecker 36 auf, die eine elektrische Trennung der Eingabe- und Ausgabeseite vom Eingang in den Elektronikmodul 2 erlaubt und eine Messung hier vorliegender elektrischer Kennwerte ermöglichen. Einspeisescheiben 26 werden bei dieser Bauart von Anschlußblocks nicht benötigt, so daß jeder Anschlußblock nur von einer Schutzleiterscheibe 25 und einer Rastfußscheibe 24 begrenzt ist.

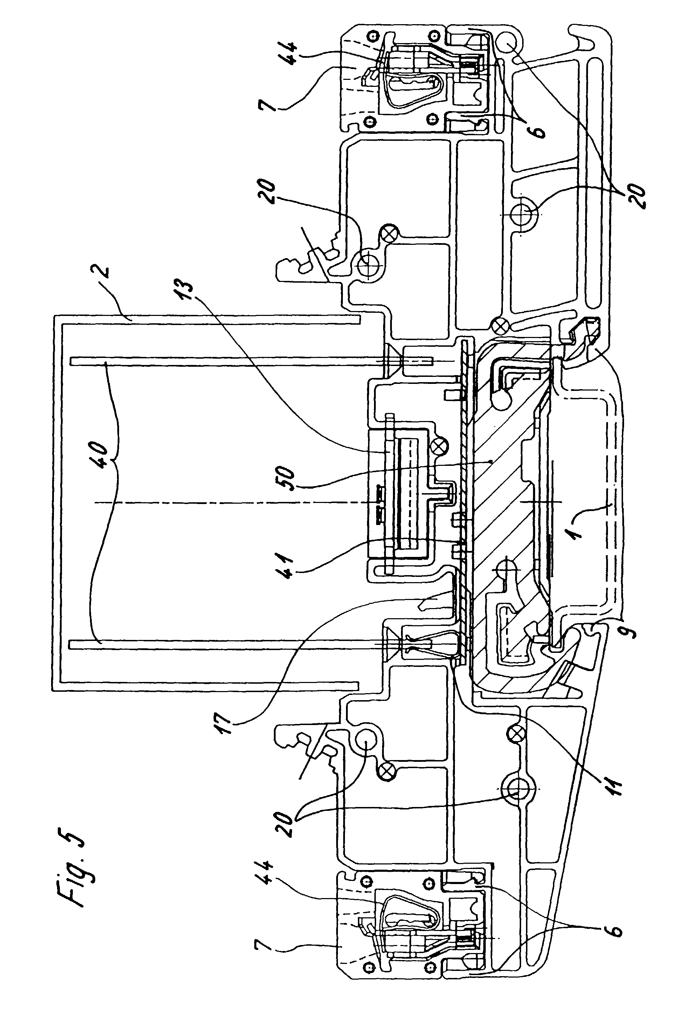

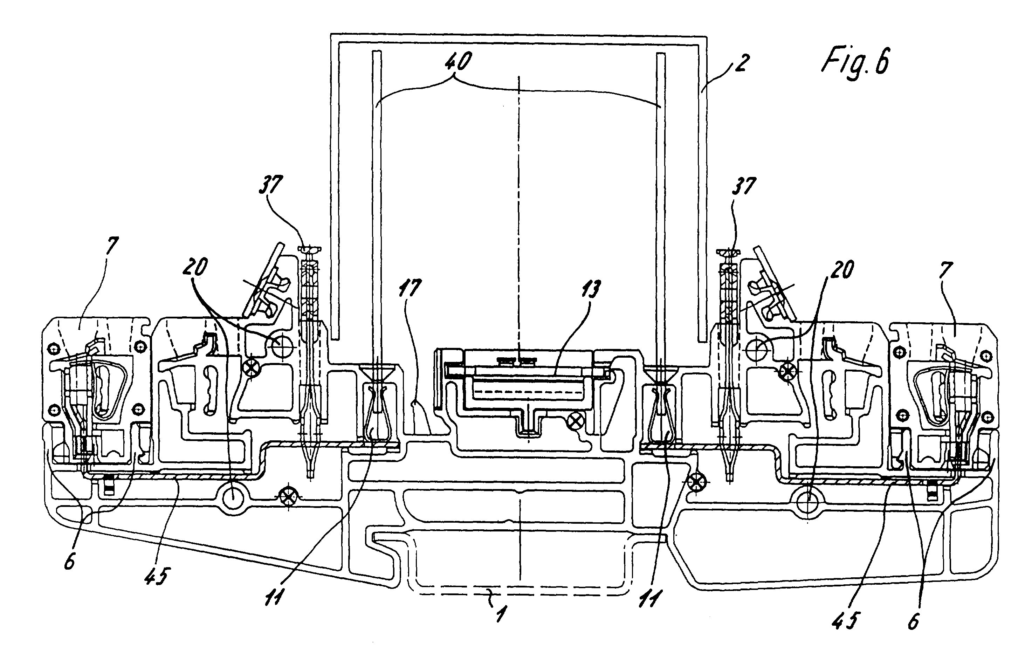

In den Figuren 5 bis 14 werden einige Beispiele des Aufbaus von Anschlußscheiben mit unterschiedlichen Funktionen dargestellt, wobei zur Beschreibung funktionsgleicher Bauelemente gleiche Sachnummern verwendet werden, so daß für die Figur 5 ausführlich der Aufbau einer Anschlußscheibe, hier einer Schutzleiterscheibe 25, mit Erläuterung aller verwendeten Sachnummern vorgenommen wird und im weiteren für die Beschreibung der Figuren 6 bis 11 nur auf die Besonderheiten der jeweiligen Schlußscheibe hinsichtlich ihrer Funktion und ihres Aufbaus verwiesen wird.

In der Figur 5 ist eine Schutzleiterscheibe 25 in einer Seitenansicht in Richtung der Tragschiene 1 mit aufgestecktem Elektronikmodul 2 sowie darunter angeordnetem Busleiterbereich 13 dargestellt. Die Schutzleiterscheibe 25 ist auf der Tragschiene 1 mittels der Rastfüße 9 aufgerastet, wobei über das Abgreifblech 50 eine Verbindung zu einem Kontaktierungssteg 41 hergestellt wird, der mit dem Steckanschluß 11 für den Anschluß des Signalleiters an den Elektronikmodul 2 verbunden ist.

Weiterhin erkennt man die Ratszapfen bzw. Rastbohrungen 20, mit denen die Schutzleiterscheibe 25 mit benachbarten Anschlußscheiben eines Anschlußblockes mechanisch gekoppelt wird. Im Bereich der Verteilung ist die jeweils außenliegend angeordnete Vorrichtung 6 zur Aufnahme der Verteilerleisten mit jeweils zur Verteilerleiste anreihbaren Anschlußelementen 7 bestückt, wobei jedes Anschlußelement 7 mittels Verrastungselementen 43 in die Vorrichtung zur Aufnahme von Verteilerleisten eingesteckt und befestigt ist. Innerhalb jedes Anschlußelementes 7 sind hier als Kabelklemmvorrichtungen 44 ausgeführte Befestigungsmöglichkeiten für in vertikaler Richtung einsteckbare Versorgungskabel vorgesehen. Die Signalleiterklemmen 8 sind in der Schutzleiterscheibe 25 nicht vorgesehen und daher ist das Gehäuse der Schutzleiterscheibe 25 hier nicht weiter bestückt. Innerhalb des Gehäuses des Elektronikmodules 2 sitzen in der schon beschriebenen Weise die Funktionsleiterplatten 40, die in den Führungsschienen 30 geführt und an ihrer Unterseite mit zu den Steckanschlüssen 11 korrespondierenden Kontaktierungsleisten 18 in die Steckanschlüsse 11 einsteckbar sind. Die zentrale Funktionsleiterplatte 23 ist hier nicht dargestellt. An der Schutzleiterscheibe 25 ist lediglich ein Steckanschluß 11 ausgeführt, der einen Schutzleiteranschluß des Elektronikmodules 2 an die Tragschiene 1 ermöglicht. Die Schutzleiterscheibe 25 hat als Funktion zum einen die Bereitstellung einer mechanischen Verrastung eines Anschlußblockes mit der Tragschiene 1, zum anderen das Abgreifen des über die Tragschiene 1 anliegenden Schutzleiters und Weiterleitung dieses Schutzleiterpotentials einerseits über den Kontaktierungssteg 41 auf den Steckanschluß 11 für den Elektronikmodul 2 und anderseits auf das Anschlußelement 7 über einen weiteren Kontaktierungssteg, der hier nicht dargestellt ist, der an dem Abgreifblech 50 anliegt und mit der Tragschiene 1 mechanischen Kontakt hat.

In der Figur 6 ist eine Einspeisescheibe 26 entsprechend dem in der Figur 5 dargestellten grundsätzlichen Aufbau gezeigt, wobei hier die Rastfußfunktion der Schutzleiterscheibe 25 nicht realisiert ist und auch kein elektrischer Kontakt mit der Tragschiene 1 besteht. Es ist lediglich eine mechanische Anlagefunktion über entsprechende Formelemente im unteren Bereich des Gehäuses der Einspeisescheibe 26 mit der Tragschiene 1 realisiert. Die Einspeisescheibe 26 dient dazu, den Elektronikmodul 2 und die aus den Anschlußelementen 7 gebildeten Verteilerleisten mit mindestens einem Spannungspotential zu versorgen, wozu die von oben in die Anschlußelemente 7 eingesteckten Kabelverbinder zur Spannungsversorgung über Kontaktierungsbleche 45 jeweils mit den Steckanschlüssen 11 für den Elektronikmodul 2 verbunden sind. Gleichzeitig wird über die Anschlußelemente 7 die Versorgungsspannung an die benachbarten Versorgungs-/Signalleiterscheiben 27 querverteilt. Auch hier ist wiederum der Signalleiterbereich nicht vorgesehen, zumindestens aber nicht elektrisch bestückt. Vorsehbar, üblicherweise aber nicht benötigt, sind Querverteilungskämme 37, die ebenfalls eine Querverteilung elektrischer Potentiale innerhalb des Anschlußblockes ermöglichen.

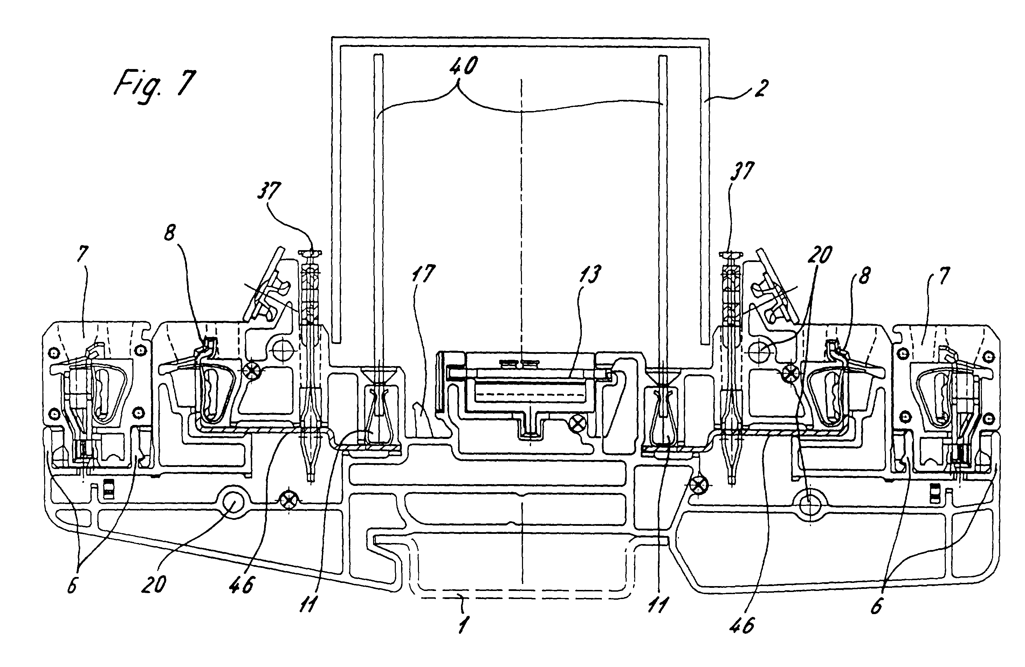

In der Figur 7 ist eine Versorgungs-/Signalleiterscheibe 27 entsprechend dem prinzipiellen Aufbau der Figuren 5 und 6 dargestellt, wobei wiederum lediglich eine mechanische Anschlagfunktion im Anschlußbereich zur Tragschiene 1 der Versorgungs-/Signalleiterscheibe 27 vorgesehen ist und die Versorgungs-/Signalleiterscheibe 27 über die Anreihbolzen 20 mit den benachbarten Scheiben verbindbar ist. Aufgabe der Versorgungs-/ Signalleiterscheibe 27 ist es, zum einen über die Querverteilung mittels der Anschlußelemente 7 von einer Einspeisescheibe 26 bereitgestellte elektrische Potentiale für den Anschluß von Initiatoren, Aktoren, Feldgeräten oder dgl. bereitzustellen und zum anderen die von diesen Initiatoren, Aktoren, Feldgeräten oder dgl. zurückkommenden Signale auf die Signalleiterklemmen 8 aufzulegen. Diese Signalleiterklemmen 8 sind mittels Kontaktierungsstegen 46 mit dem Elektronikmodul 2, hier mit den beiden Steckanschlüssen 11 für den Anschluß des Elektronikmodules 2 verbunden. Die dargestellte Versorgungs-/Signalleiterscheibe 27 erlaubt also den Anschluß jeweils beidseitig eines Initiators, Aktors, Feldgerätes oder dgl. mit je einer Signalleitung, wobei für die Versorgung ein Potential von den Anschlußelementen 7 abgreifbar ist.

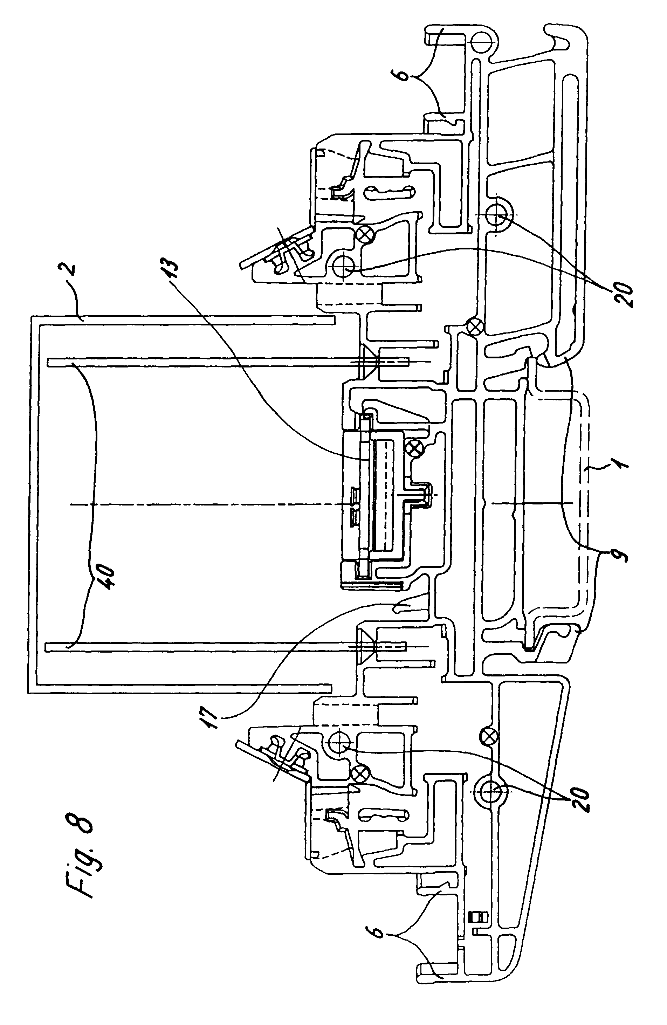

In der Figur 8 ist eine Rastfußscheibe 24 dargestellt, die in entsprechender Weise zur Schutzleiterscheibe 25 der Figur 5 mit der Tragschiene 1 verrastbar ausgeführt ist, wobei aber der elektrische Anschluß an die Tragschiene 1 entfällt. Die Vorrichtungen 6 zur Aufnahme von Verteilerleisten sind nicht bestückt, ebenfalls ist eine Bestückung der Signalleiteranschlüsse 8 nicht vorgesehen.

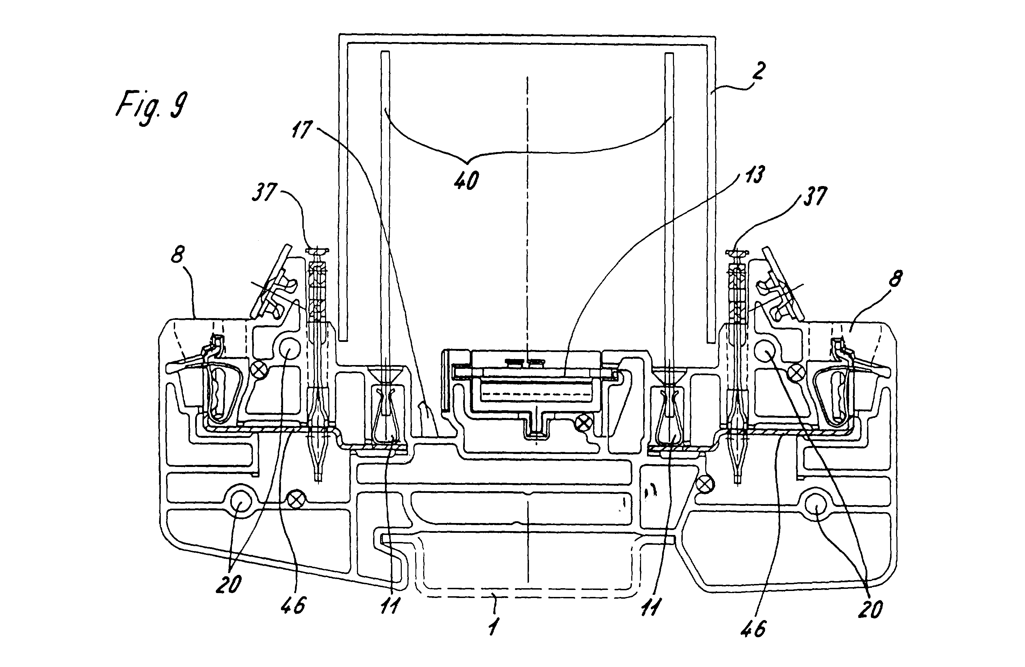

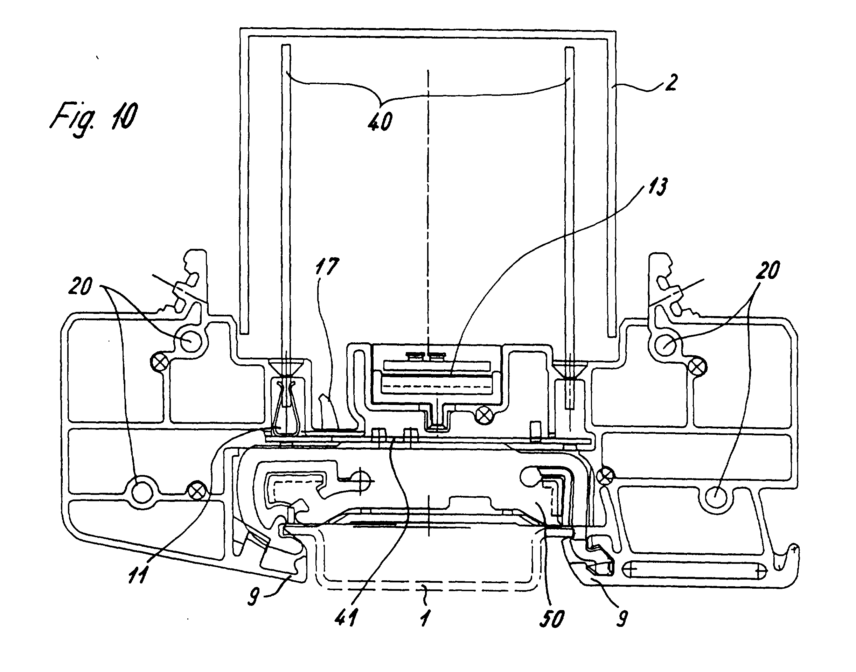

In den Figuren 9 und 10 sind Anschlußscheiben dargestellt, die keine Vorrichtungen zur Aufnahme von Verteilerleisten aufweisen, ansonsten aber dem prinzipiellen Aufbau der vorstehenden Figuren entsprechen. In der Figur 9 ist eine Versorgungs-Signalleiterscheibe 27 dargestetllt, in der Figur 10 eine Schutrleiterscheibe 25.

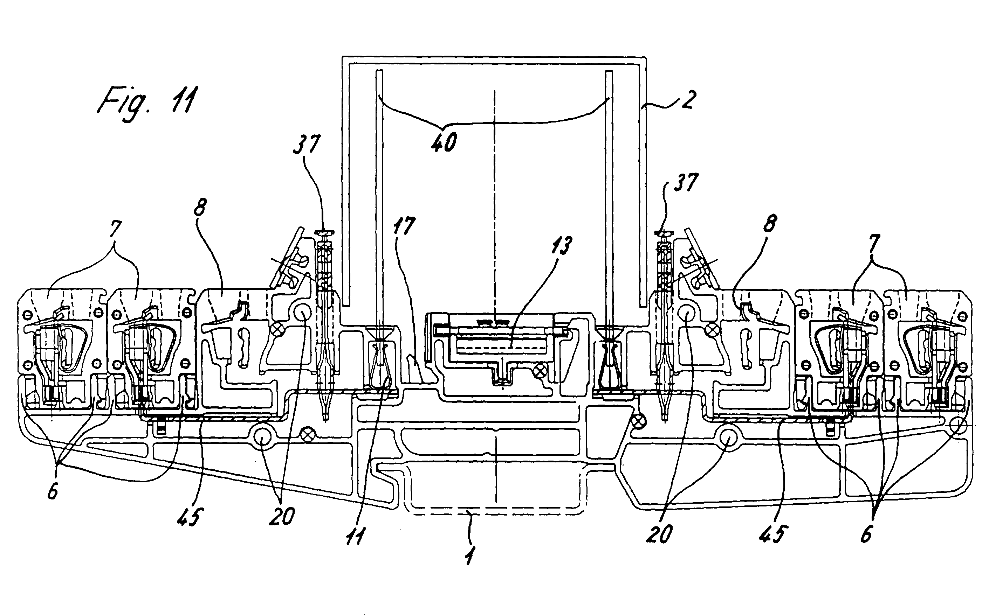

In den Figuren 11 bis 13 sind Anschlußscheiben der vorstehend erwähnten Art dargestellt, die zwei Vorrichtungen 6 zur Aufnahme von Verteilerleisten aufweisen, wobei die einzigen Unterschiede hinsichtlich der vorstehend angeführten Bauformen darin bestehen, daß an jeder Seite des Elektronikmodules 2 zwei verschiedene Potentiale zum Abgriff durch die Initiatoren, Aktoren oder Feldgeräte oder dgl. zur Verfügung stehen und somit ein Anschluß von Initiatoren, Aktoren, Feldgeräten oder dgl. in Dreileitertechnik möglich ist.

In der Figur 11 ist eine Einspeisescheibe 26 dargestellt, bei der beidseitig jeweils ein Minuspotential auf den inneren Verteilerleisten zur Verfügung steht, wobei jeweils außen auf der einen Seite ein Pluspotential und auf der anderen Seite ein Schutzleiteranschluß in den Verteilerleisten vorgesehen ist. Sowohl der Plusanschluß als auch der Schutzleiteranschluß werden über die Querverteilung von einer anderen Einspeisescheibe 26, bzw. von der zugeordneten Schutzleiterscheibe querverteilt.

Bei der Einspeisescheibe 26 der Figur 11 ist der Signalleiterbereich 8 nicht bestückt, wobei je nach Ausbildung einer derartigen Einspeisescheibe 26 auch nur eine Hälfte einer derartrgen Einspeisescheibe 26 zur Einspeisung genutzt werden kann und die anderen Hälfte in der schon vorstehend beschriebenen Art von Anschluß von Initiatoren, Aktoren, Feldgeräten oder dgl. nutzbar ist.

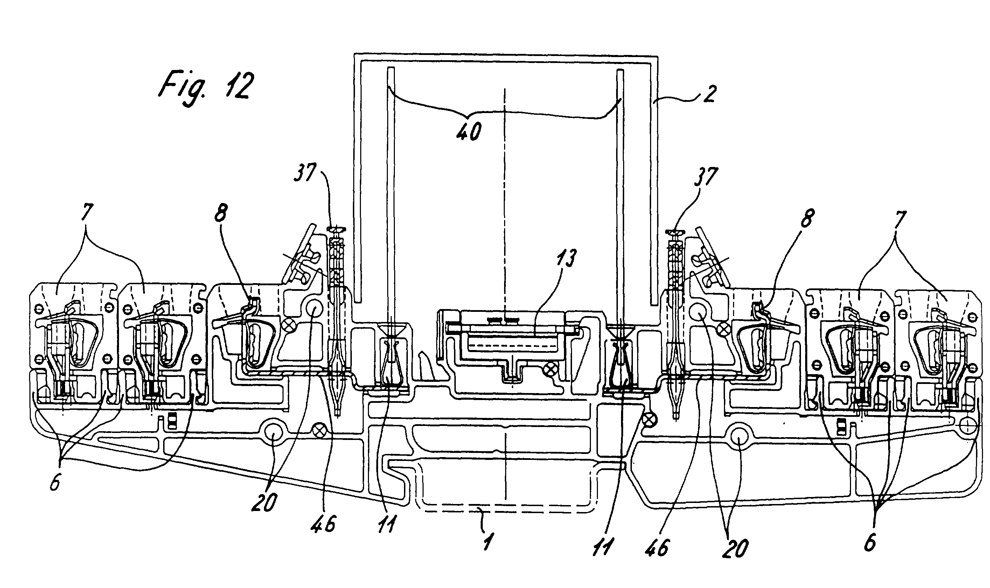

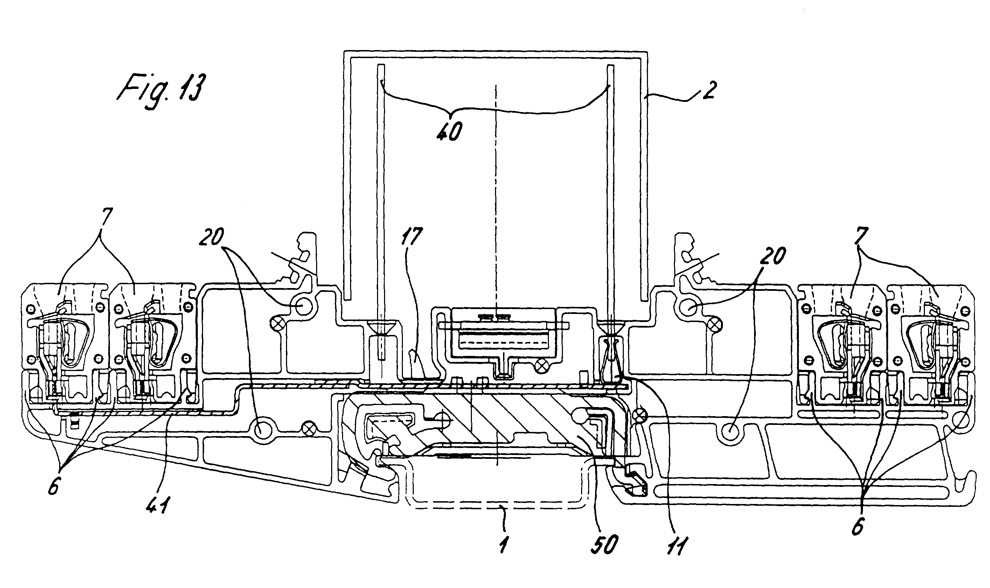

In der Versorgungs-/Signalleiterscheibe 27 der Figur 12 sind die Anschlußelemente 7 nur zur Querverteilung der von Einspeisescheiben 26 bzw. Schutzleiterscheibe 25 querverteilten elektrischen Potentiale vorgesehen, hingegen ist der Signalleiterbereich 8 bestückt und für die Einführung von Signalleitern mit dem Elektronikmodul 2 verbunden. Hierzu dienen Kontaktierungsbleche 46 zwischen den Signalleitersteckanschlüssen 11 und dem Signalleiteranschluß 8. Die Schutzleiterscheibe 25 der Figur 13 weist neben dem schon erwähnten Aufbau als Besonderheit auf, daß zusätzlich zur Weiterleitung des Schutlleiterpotentials an den Elektronikmodul 2 mittels eines Abgreifbleches 50 ein weiterer Kontaktierungssteg 41 vorgesehen ist, der das Schutzleiterpotential auf eine einseitig angeordnete querverteilende Verteilungsleiste aus Anschlußelementen 7 weiterleitet.

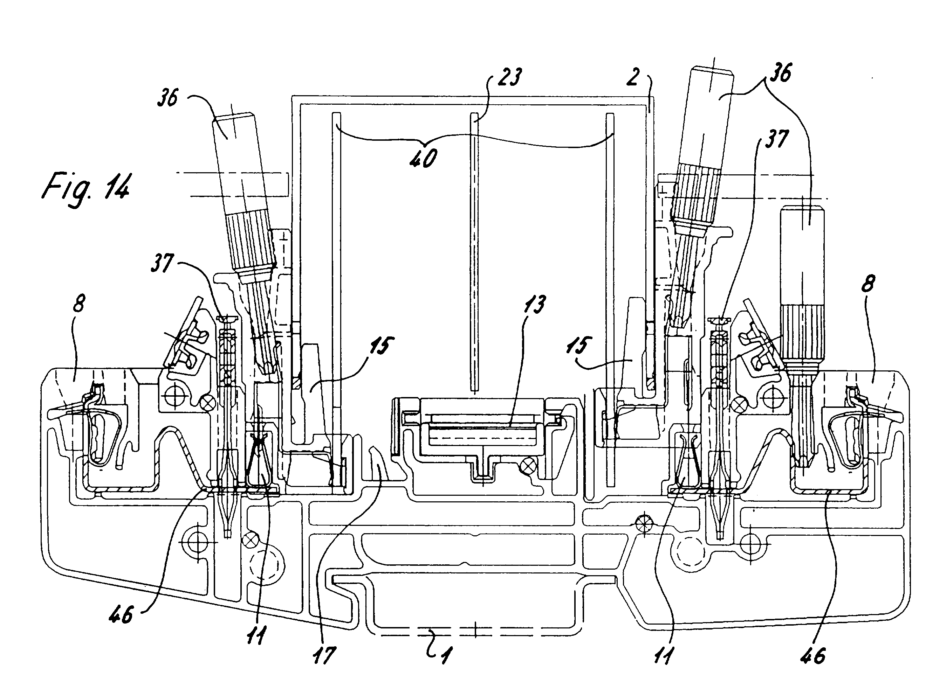

In der Anschlußscheibe der Figur 14 ist eine Versorgungs-/Signalleiterscheibe 27 in einer bevorzugten Ausführungsform dargestellt, die zur elektrischen Trennung der Verbindungen zwischen Elektronikmodul 2 und Signalleiteranschlüssen 8 dient. Hierzu werden Trennstecker 36 beidseits des Elektronikmodules 2 vorgesehen, die eine Trennung der elektrischen Leitung ermöglichen und somit einen Abgriff von elektrischen Meßwerten an definierten Stellen innerhalb des Steuerungssystems ermöglichen.

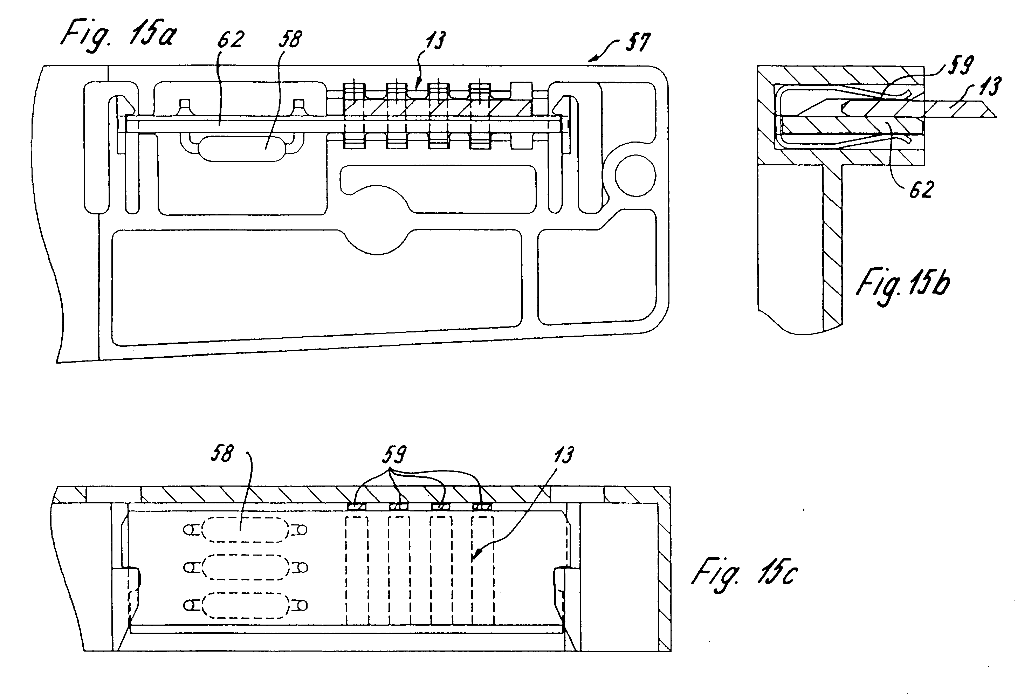

In den Figuren 15a - 15c ist aufgezeigt, wie eine Abschlußscheibe 57 am Ende des Busleiterbereichs 13 steckbar auf der Busleiterplatine angeordnet ist, um eine Signalreflexion am Ende des Busleiters 13 zu verhindern. Hierzu wird eine kleine separate Platine 62 innerhalb der im wesentlichen aus einem Stecksockel gebildeten Abschlußscheibe 57 so angeordnet, daß sie beim Aufstecken auf die Busleiterplatine 13 unterhalb dieser zu liegen kommt und mittels auf die Abschlußscheibe 57 aufsteckbaren Verbindungsfedern 59 mit den Leiterbahnen auf der Busleiterplatine 13 verbindbar ist. Unterhalb der separaten Platine 62 sitzen die Abschlußwiderstände 58, die zwischen die Einzelleiter des Busleiters 13 geschaltet werden, um unerwünschte Signalreflexionen am Ende des Busleiters 13 zu verhindern.

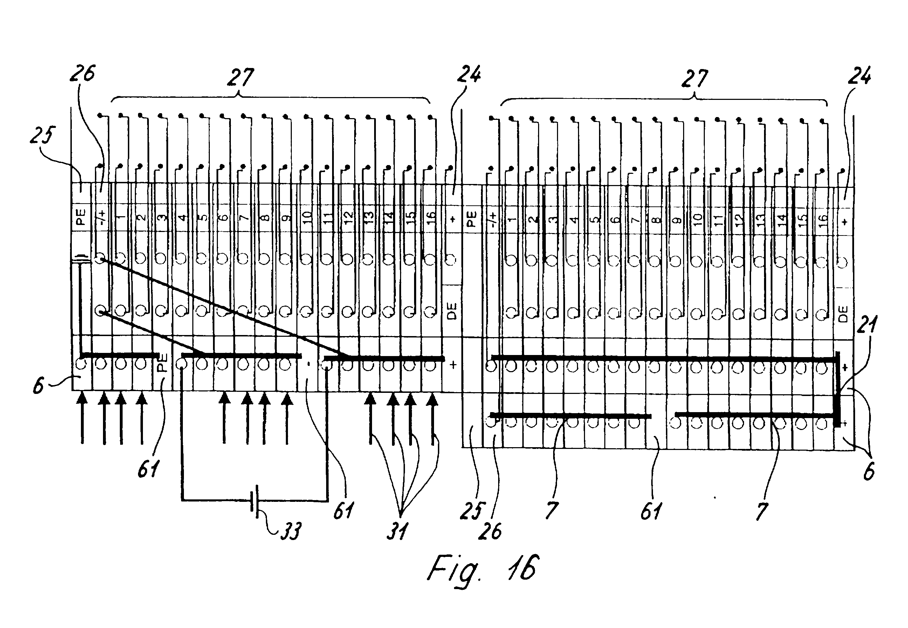

In der Figur 16 ist an einer Seite eines Anschlußblockes eine weitere Möglichkeit dargestellt, wie innerhalb einer durch Reihung von Anschlußelementen 7 gebildeten Verteilerleiste auch unterschiedliche elektrische Potentiale aufgelegt werden können. Hierzu wird zwischen die Bereiche gleichen elektrischen Potentials, die durch die querverbindenden Anschlußelemente 7 gebildet werden, an den Übergangsstellen mindestens je ein nicht querverbindendes Trennelement 61 eingesteckt, das von den mechanischen Anschlußmaßen den Anschlußelementen 7 entspricht, elektrisch jedoch nicht bestückt ist. Hierdurch wird die Querverbindung der gereihten Anschlußelemente 7 unterbrochen und es kann an dem darauffolgenden Anschlußelement 7 der Reihung beispielsweise über eine externe Spanungsversorgung 33 oder eine interne Verbindung zur Einspeisescheibe 26 ein anderes elektrisches Potential aufgelegt werden. Hierdurch ist es im besonderen möglich, bei nicht für gleichartige Initiatoren/Aktoren/Feldgeräte oder dgl. aufgebaute Anschlußblöcke 3 eine einfache Versorgung mit unterschiedlichen elektrischen Potentialen zu ermöglichen. Es ist weiterhin möglich, dies nicht querverbindenden Trennelemente 61 dazu zu nutzen, die angelegten elektrischen Potentiale z.B. in Form einer Beschriftung kenntlich zu machen. Es ist ebenfalls denkbar, die schon angeführte Möglichkeit zum Einstecken eines Brückenelementes 21 zur elektrischen Verbindung zweier Verteilerleisten mit der vorstehend genannten Möglichkeit der scheibenweise unterschiedlichen elektrischen Potential zu kombinieren.

### Bezugszeichenliste

- 1: Tragschiene
- 2: Elektronikmodul bzw. Gehäuse des Elektronikmodules
- 3: Anschlußblock
- 4: Gatewayscheibe
- 5: Anschlußscheiben
- 6: Vorrichtungen zur Aufnahme von Verteilerleisten
- 7: Anschlußelemente, reihbar zur Verteilerleiste
- 8: Signalleiteranschlüsse
- 9: Rastfüße
- 10: Verbindungselemente Kabel
- 11: Steckanschlüsse f. Signalleiter an Elektronikmodul
- 12: Steckverbinder interner Busleiter an Elektronikmodul
- 13: Busleiter
- 14: Trennschieber
- 15: Führungsfläche mit T-Nuten
- 16: Führungslaschen
- 17: Rasthaken
- 18: Justierungsprofil
- 19: Verrastungselemente
- 20: Anreihbolzen bzw. -bohrung
- 21: Führungsleisten f. Steckanschlüsse d. Signalleiter
- 22: Gegenstück zu Steckverbinder 11
- 23: Zentrale Funktionsleiterplatte
- 24: Rastfußscheibe
- 25: Neutralleiterscheibe
- 26: Einspeisescheibe
- 27: Versorgungs-/Signalleiterscheibe
- 28.: Verbindungsstege Funktionsleiterplatten
- 30: Führungsschienen für Funktionsleiterplatten
- 31: Sensor, aktiv mit Gleichspannungsversorgung und einer Signalleitung
- 32: Sensor, passiv
- 33: Externe Spannungsversorgung
- 34: Sensor, aktiv mit Neutralleiter und einer Signalleitung
- 25: Sensor mit 4-Leiter-Anschluß
- 36: Trennstecker
- 37: Querverteilerkamm
- 38: Aktor mit einer Signalleitung
- 40: Funktionsleiterplatte
- 41: Kontaktierungssteg Neutralleiter/Elektronikmodul/ Verteilerleiste
- 45: Kontaktierungssteg/Einspeisung/Elektronikmodul
- 46: Kontaktierungssteg/Signalleiter/Elektronikmodul
- 50: Abgreifblech
- 57: Abschlußscheibe
- 58: Abschlußwiderstand
- 59: Verbindungsfeder
- 61: Nicht-querverbindendes Trennelement
- 62: Trägerplatine

## Patentansprüche

1. Modulare Steuerungsanlage für elektronische Steuerungs- und Gebäudeautomatisierungssysteme bestehend aus
- mindestens zwei auf eine gemeinsame Tragschiene (1) klemmbaren und anreihbaren Anschlußblöcken (3) aus je einer Anzahl anreihbarer Anschlußscheiben (24, 25, 26, 27) und darin angeordneten Versorgungsanschlüssen und/oder Signalleiteranschlüssen für zugeordnete Initiatoren, Aktoren, Feldgeräte oder dgl.,
- Einrichtungen zur Verteilung elektrischer Potentiale innerhalb desselben Anschlußblocks (3),
- einem internen Busleiter (13) zur Verbindung aller auf der Tragschiene (1) angeordneter Anschlußblöcke (3),
- mindestens einem Elektronikmodul (2) zur Signalbe- und -verarbeitung bei der Verbindung von an die Signalleiter anschließbaren Initiatoren, Aktoren, Feldgeräten oder dgl. mit dem internen Busleiter (13),
- ein Anschlußmodul (4) für den Anschluß des internen Busleiters (13) an einen zugeordneten Feldbus,
**dadurch gekennzeichnet, daß**
- innerhalb jedes Anschlußblocks (3) mindestens eine Schutzleiterscheibe (25), mindestens eine Einspeisescheibe (26) und mindestens eine Versorgungs-/Signalleiterscheibe (27) angeordnet sind, deren vorgegebene Funktionsbereiche einen strukturierten Aufbau in fester nänmlicher Aufeinanderfolge aufweisen,
- die Schutzleiterscheibe (25) Bereiche zum Abgriff eines Schutzleiterpotentials von der Tragschiene (1) und zum Weiterleiten des Schutzleiterpotentials auf das Elektronik-Modul (2) aufweist,
- die Einspeisescheibe (26) Bereiche zur Versorgung des Elektronikmoduls (2) und zur Versorgung von aus Anschlußelementen (7) gereihten Verteilerleisten mit mindestens einem Spannungspotential aufweist, und
- die Versorgungs-/Signalleiterscheibe (27) Bereiche zur Querverteilung elektrischer Potentiale an weitere Anschlußscheiben desselben Anschußblocks, an welche zugeordnete Initiatoren, Aktoren, Feldgeräte o.dgl. anschließbar sind sowie Bereiche zum Signalleiteranschluß der zugeordneten Initiatoren, Aktoren, Feldgeräte o.dgl. aufweist, wobei an jeder der Versorgungs-/Signalleiterscheiben die Bereiche zur Querverteilung elektrischer Potentiale und zum Signalleiteranschluß beidseitig quer zur Tragschiene (1) vorgesehen sind,
wobei die nänmliche Anordnung der Anschlußscheiben (24, 25, 26, 27) in allen Anschlußblöcken (3) in derselben Reihenfolge erfolgt.

2. Modulare Steuerungsanlage nach Anspruch 1, dadurch gekennzeichnet, daß die Anschlußscheiben ferner einen Bereich zur lösbaren Anordnung des Elektronikmoduls (2) oberhalb der Tragschiene (1) und oberhalb des mittig zum Anschlußblock und unter dem Elektronikmodul angeordneten internen Busleiters (13) aufweisen, mit dem der Elektronikmodul elektrisch steckverbindbar ist

3. Modulare Steuerungsanlage nach Anspruch 1 oder 2, dadurch gekennzeichnet, daß die Bereiche zur Querverteilung elektrischer Potentiale und zum Signal- und Leiteranschluß beidseits der Tragschiene Funktionsidentisch sind.

4. Modulare Steuerungsanlage nach Anspruch 1,2 oder 3, dadurch gekennzeichnet, daß an den ersten Bereich zum Signalleiteranschluß (8) zugeordneter Initiatoren, Aktoren, Feldgcräte o.dgl. auch deren Versorgungsleitungen anschließbar sind.

5. Modulare Steuerungsanlage nach einem der vorstehenden Ansprüche, dadurch gekennzeichnet, daß die Schutzleiterscheibe ferner Bereiche zum Weiterleiten des Schutzleiterpotentials wenigstens eines der Anschlußelemente (7) aufweist.

6. Modulare Steuerungsanlage nach Anspruch 1 oder 2, dadurch gekennzeichnet, daß innerhalb jedes Anschlußblocks (3) die Anschlußscheiben (24-27) in der Reihenfolge: eine Schutzleiterscheibe (25), mindestens eine Einspeisescheibe (26), an die Einspeisesscheibe anschließend mindestens eine Versorgungs-/ Signalleiterscheibe (27) und ggf. eine Rastfußscheibe (24) angeordnet sind.

7. Modulare Steuerungsanlage nach einem der Ansprüche 1 bis 6, **dadurch gekennzeichnet, daß** die Anschlußscheiben quer zur Tragschiene einen symmetrischen Aufbau bezüglich des Elektronikmodules aufweisen.

8. Modulare Steuerungsanlage nach einem der Ansprüche 1 bis 7, **dadurch gekennzeichnet, daß** die Schutzleiterscheibe (25) einen mechanischen und elektrischen Anschluß zur Tragschiene (1) und einen Steckanschluß (11) zum Elektronikmodul (2) aufweist.

9. Modulare Steuerungsanlage nach einem der Ansprüche 1 bis 8, **dadurch gekennzeichnet, daß** die Schutzleiterscheibe (23) mit der Potentialverteilung an weitere Anschlußscheiben (24, 26, 27) desselben Anschlußblocks (3) verbindbar ist.

10. Modulare Steuerungsanlage nach einem der Ansprüch 1 bis 7, **dadurch gekennzeichnet, daß** die Einspeisescheibe (26) mit der Potentialverteilung an weitere Anschlußscheiben (24-27) desselben Anschlußblocks (3) und dem Elektronikmodul (2) verbindbar ist.

11. Modulare Steuerungsanlage nach einem der Ansprüche 1 bis 7 oder 10, **dadurch gekennzeichnet, daß** bei einer Bauform mit mindestens je einer Vorrichtung (6) zur Aufnahme von Verteilerleisten beidseits des Elektronikmodules (2) die Einspeisung des zugehörigen elektrischen Potentials für jede Seite an mindestens einer als jeweils zweitäußerste Anschlußscheibe von beiden Enden des Anschlußblockes (3) angeordneten Einspeisescheibe (26) erfolgt, wobei die Einspeisung vorzugsweise nur einseitig des Elektronikmodules (2) erfolgt und der gegenüberliegende Bereich der Einspeisescheibe (26) zum Anschluß von Initiatoren, Aktoren, Feldgeräten oder dgl. nutzbar ist.

12. Modulare Steuerungsanlage nach einem der Ansprüche 1, bis 6, 10 oder 11, **dadurch gekennzeichnet, daß** an der Einspeisescheibe (26) nur eine Verbindung zum Elektronikmodul (2) besteht.

13. Modulare Steuerungsanlage nach einem der Ansprüche 1 bis 7, **dadurch gekennzeichnet, daß** die Versorgungs-/ Signalleiterscheibe (27), wenn erforderlich, aus Vorrichtungen (6) zur Aufnahme von Verteilerleisten, Signalleiteranschlüssen (8) und Steckanschlüssen für den Elektronikmodul (11) besteht.

14. Modulare Steuerungsanlage nach einem der Ansprüche 1 bis 5 oder 13, **dadurch gekennzeichnet, daß** jede Vorrichtung (6) zur Aufnahme von Verteilerleisten Befestigungskonturen für in die Verteilerleisten einsteckbare und rastbare, vorzugsweise farbig gestaltbare, auch querverteilende Anschlußelemente (7) aufweist.

15. Modulare Steuerungsanlage nach einem der Ansprüche 1 bis 5 oder 13, **dadurch gekennzeichnet, daß** bei einer Bauform ohne Verteilerleisten auf einer Seite die Signalleiteranschlüsse durch Querverteilungskämme mit einem Anschluß der Einspeisescheibe (26) verbindbar sind, wobei auf der anderen Signalleiterseite die Rückführung der Signale jedes zugeordneten Initiators, Aktors, Feldgerätes od. dgl. erfolgt.

16. Modulare Steuerungsanlage nach einem der Ansprüche 1 bis 7, **dadurch gekennzeichnet, daß** auf jeder der beiden Seiten des Elektronikmoduls (2) an jeder Versorgungs-/ Signalleiterscheibe jeweils ein Initiator, Aktor, Feldgerät oder dgl. anschließbar ist.

17. Modulare Steuerungsanlage nach einem der vorstehenden Ansprüche, **dadurch gekennzeichnet, daß** jeder Anschlußblock (3) an beiden Durchtrittsseiten der Tragschiene (1) Anschlußscheiben (24, 25) aufweist, die jeweils der Tragschiene (1) zugeordnete Rastfüße (9) zur mechanischen Klemmung auf und/oder elektrischen Verbindung mit dieser Tragschiene (1) aufweisen.

18. Modulare Steuerungsanlage nach einem der Ansprüche 1 bis 5 oder 17, **dadurch gekennzeichnet, daß** eine Rastfußscheibe (24) ausschließlich mechanischen Anschluß zur Tragschiene (1) hat.

19. Modulare Steuerungsanlage nach einem der vorstehenden Ansprüche, **dadurch gekennzeichnet, daß** die Anschlüsse gleichartiger Initiatoren, Aktoren, Feldgeräte oder dgl. nach Bedarf in Anschlußblocks (3) gleichartiger Anschlußscheiben (27) zusammenfaßbar sind.

20. Modulare Steuerungsanlage nach einem der vorstehenden Ansprüche, **dadurch gekennzeichnet, daß** die Anschlüsse unterschiedlicher Initiatoren, Aktoren, Feldgeräte oder dgl. nach Bedarf in Anschlußblocks (3) unterschiedlicher Anschlußscheiben (27) zusammenfaßbar sind.

21. Modulare Steuerungsanlage nach einem der Ansprüche 1 bis 5, **dadurch gekennzeichnet, daß** der interne Busleiter (13) aus Busschienenstücken besteht, die über verschiebbare und rastbare Trennschieber (14) lösbar und elektrisch/mechanisch mit den benachbarten Busleiterstücken verbindbar sind.

22. Modulare Steuerungsanlage nach einem der vorstehenden Ansprüche, **dadurch gekennzeichnet, daß** der Busleiterbereich (13) auf der von der Tragschiene (1) abgewandten Seite durch den gesteckten Elektronikmodul (2) verdeckt ist und die miteinander verbindbaren Busschienenstücke erst nach Abnehmen des Elektronikmoduls (2) zugänglich sind.

23. Modulare Steuerungsanlage nach einem der Ansprüche 1 bis 5 oder 22, **dadurch gekennzeichnet, daß** der über die Anschlußscheiben abgewandt von der Tragschiene (1) hervorstehende Elektronikmodul (2) mit seinen Gehäuseabmessungen zu den Einbaumaßen in Kleinverteilungsanlagen passend ist.

24. Modulare Steuerungsanlage nach einem der vorstehenden Ansprüche, **dadurch gekennzeichnet, daß** an dem dem feldbusseitigen Ende abgewandten Ende des internen Busleiters (13) eine steckbare Abschlußscheibe (57) mit Abschlußwiderständen (58) vorsehbar ist, die vorzugsweise als Steckschuh mit einer an der internen Busleiterplatine (13) angeordneten, die Abschlußwiderstände (58) tragenden Platine (62) ausführbar ist.

25. Modulare Steuerungsanlage nach einem der vorstehenden Ansprüche, **dadurch gekennzeichnet, daß** jedes Elektronikmodul (2) mindestens je einen steckbaren und lösbaren Steckanschluß (11) zur Verbindung mit den Signalleitern der Initiatoren, Aktoren, Feldgeräte oder dgl. und mit dem internen Busleiter (13) sowie diese Steckanschlüsse verbindende Funktionsleiterplatten (40) enthält.

26. Modulare Steuerungsanlage nach einem der Ansprüche 1 bis 5 oder 13, **dadurch gekennzeichnet, daß** bei Anschluß digitaler Initiatoren an den Anschlußblock (3) nur die Signalleitung anschließbar sind, wobei die Versorgung dieser Initiatoren mit benötigten elektrischen Potentialen vorzugsweise außerhalb des Anschlußblocks (3) erfolgt.

27. Modulare Steuerungsanlage nach einem der Ansprüche 1 bis 5 oder 13, **dadurch gekennzeichnet, daß** bei Anschluß aktiver Initiatoren/Aktoren/Feldgeräte immer mindestens je eine vorrichtung (6) zur Aufnahme von Verteilerleiste und mindestens je ein Signalleiteranschluß (8) vorgesehen sind.

28. Modulare Steuerungsanlage nach einem der Ansprüche 1 bis 5 oder 7, **dadurch gekennzeichnet, daß** der Elektronikmodul (2) ein veränderbar codiertes Gehäuse aufweist.

29. Modulare Steuerungsanlage nach einem der Ansprüche 1 bis 5 oder 25, **dadurch gekennzeichnet, daß** bei entferntem Elektronikmodul (2) alle restlichen an einer Tragschiene (1) angeordneten Anschlußblocks (3) voll funktionsfähig sind.

30. Modulare Steuerungsanlage nach einem der Ansprüche 1 bis 5 oder 13, **dadurch gekennzeichnet, daß** der Leiteranschluß an die Anschlußblocks (3) von der der Tragschiene (1) abgewandten Seite erfolgt und daß das Elektronikmodul (2) ohne Lösen der Verdrahtung abnehmbar ist.

31. Modulare Steuerungsanlage nach einem der vorstehenden Ansprüche, **dadurch gekennzeichnet, daß** zum Prüfen des Elektronikmodules (2) sowie der Signalzustände der angeschlossenen Signalleiter Trennstecker vorsehbar sind.

32. Modulare Steuerungsanlage nach einem der vorstehenden Ansprüche, **dadurch gekennzeichnet, daß** die Signalanpassung zur Anbindung des internen Busleiters (13) an einen übergeordneten Feldbus in einem an der Tragschiene (1) angeordneten Feldbusanschlußmodul (4) erfolgt.

33. Modulare Steuerungsanlage nach einem der vorstehenden Ansprüche, **dadurch gekennzeichnet, daß** die elektrische Anbindung des internen Busleiters (13) an einen übergeordneten Feldbus mittels einer Direktverdrahtung an dem am Anfang der Tragschiene (1) angeordneten Feldbusanschlußmodul (4) erfolgt.

34. Modulare Steueranlage nach Anspruch 1 bis 5 oder 14, **dadurch gekennzeichnet, daß** in die Vorrichtungen (6) zur Aufnahme von Verteilerleisten nicht querverbindende Elemente (61) einsteckbar sind, durch die in eine Verteilerleiste eingespeiste unterschiedliche elektrische Potentiale elektrisch voneinander trennbar sind.

## Claims

1. A modular control installation for electronic control and building automation systems comprising
- at least two connection blocks (3) which can be arranged in a row and clamped on a common mounting rail (1) and each comprise a number of connection plates (24. 25, 26, 27) which can be arranged in a row, and arranged therein supply connections and/or signal conductor connections for associated initiators, actuators, field devices or the like,
- devices for the distribution of electrical potentials within the same connection block (3),
- an internal bus conductor (13) for connecting all connection blocks (3) arranged on the mounting rail (1).
- at least one electronic module (2) for signal conditioning and processing in the connection of initiators, actuators. field devices or the like which can be connected to the signal conductors, to the internal bus conductor (13), and
- a connection module (4) for the connection of the internal bus conductor (13) to an associated field bus.
characterised in that
- arranged within each connection block (3) are at least one protective conductor plate (25), at least one feed-in plate (26) and at least one supply/signal conductor plate (27). whose predetermined functional regions have a structured construction in fixed spatial succession.
- the protective conductor plate (25) has regions for tapping off a protective conductor potential from the mounting rail (1) and for transmitting the protective conductor potential to the electronic module (2).
- the feed-in plate (26) has regions for supplying the electronic module (2) and for supplying distributor links ranged out of connection elements (7) with at least one voltage potential, and
- the supply/signal conductor plate (27) has regions for the cross-distribution of electrical potentials to further connection plates of the same connection block to which associated initiators. actuators, field devices or the like can be connected and regions for the signal conductor connection of the associated initiators, actuators, field devices or the like, wherein at each of the supply/signal conductor plates the regions for the cross-distribution of electrical potentials and for the signal conductor connection are provided on both sides transversely with respect to the mounting rail (1). wherein the spatial arrangement of the connection plates (24. 25. 26. 27) in all connection blocks (3) occurs in the sane sequence.

2. A modular control installation according to claim 1 characterised in that the connection plates also have a region for the releasable arrangement of the electronic module (2) above the mounting rail (1) and above the internal bus conductor (13) which is arranged centrally with respect to the connection block and beneath the electronic module and to which the electronic module can be electrically plug-connected.

3. A modular control installation according to claim 1 or claim 2 characterised in that the regions for the cross-distribution of electrical potentials and for signal and conductor connection are functionally identical on both sides of the mounting rail.

4. A modular control installation according to claim 1, claim 2 or claim 3 characterised in that it is also possible to connect to the first region of initiators, actuators. field devices or the like associated with the signal conductor connection (8) the supply lines thereof.

5. A modular control installation according to one of the preceding claims characterised in that the protective conductor plate also has regions for transmitting the protective conductor potential of at least one of the connection elements (7).

6. A modular control installation according to claim 1 or claim 2 characterised in that arranged within each connection block (23) are the connection plates (24 - 27) in the sequence: a protective conductor plate (25), at least one feed-in plate (26), adjoining the feed-in plate at least one supply/signal conductor plate (27) and possibly a retaining base plate (24).

7. A modular control installation according to one of claims 1 to 6 characterised in that the connection plates. transversely with respect to the mounting rail, are of a symmetrical structure with respect to the electronic module.

8. A modular control installation according to one of claims 1 to 7 characterised in that the protective conductor plate (25) has a mechanical and electrical connection to the mounting rail (1) and a plug connection (11) to the electronic module (2).

9. A modular control installation according to one of claims 1 to 8 characterised in that the protective conductor plate (23) can be connected with the potential distribution to further connection plates (24. 26. 27) of the same connection block (3).

10. A modular control installation according to one of claims 1 to 7 characterised in that the feed-in plate (26) can be connected with the potential distribution to further connection plates (24-27) of the same connection block (3) and the electronic module (2).

11. A modular control installation according to one of claims 1 to 7 or 10 characterised in that in a design with at least one respective device (6) for receiving distributor links on both sides of the electronic module (2) the feed-in of the associated electrical potential for each side is effected at at least one feed-in plate (26) arranged as the respective second most outward connection plate from the two ends of the connection block (3). wherein the feed-in is preferably effected only at one side of the electronic module and the oppositely disposed region of the feed-in plate (26) can be used for the connection of initiators, actuators, field devices or the like.

12. A modular control installation according to one of claims 1 to 6, 10 or 11 characterised in that there is only one connection to the electronic module (2) on the feed-in plate (26).

13. A modular control installation according to one of claims 1 to 7 characterised in that the supply/signal conductor plate (27). if necessary, comprises devices (6) for accommodating distributor links, signal conductor connections (8) and plug connections for the electronic module (11).

14. A modular control installation according to one of claims 1 to 5 or 13 characterised in that each device (6) for accommodating distributor links has fixing contours for connection elements (7) which can be plugged into and retained in the distributor links and which can preferably be coloured and which also provide for cross-distribution.

15. A modular control installation according to one of claims 1 to 5 or 13 characterised in that in a design without distributor links on one side the signal conductor connections can be connected by cross-distribution combs to a connection of the feed-in plate (26) while on the other signal conductor side feed-back of the signals of each associated initiator, actuator, field device or the like is effected.

16. A modular control installation according to one of claims 1 to 7 characterised in that a respective initiator, actuator, field device or the like can be connected on each of the two sides of the electronic module (2) to each supply/signal conductor plate.

17. A modular control installation according to one of the preceding claims characterised in that each connection block (3) has at both passage sides of the mounting rail (1) connection plates (24, 25) which have respective retaining bases (9) associated with the mounting rail (1) for mechanical clamping on and/or electrical connection to said mounting rail (1).

18. A modular control installation according to one of claims 1 to 5 or 17 characterised in that a retaining base plate (24) has exclusively a mechanical connection to the mounting rail (1).

19. A modular control installation according to one of the preceding claims characterised in that the connections of similar initiators, actuators, field devices or the like can be combined if required in connection blocks (3) of similar connection plates (27).

20. A modular control installation according to one of the preceding claims characterised in that the connections of different initiators. actuators, field devices or the like can be combined if necessary in connection blocks (3) of different connection plates (27).

21. A modular control installation according to one of claims 1 to 5 characterised in that the internal bus conductor (13) comprises bus bar portions which by way of displaceable and latchable separating sliders (14) can be releasably and electrically/mechanically connected to the adjacent bus conductor portions.

22. A modular control installation according to one of the preceding claims characterised in that the bus conductor region (13) on the side remote from the mounting rail (1) is concealed by the inserted electronic module (2) and the bus bar portions which can be connected together are accessible only after removal of the electronic module (2).

23. A modular control installation according to one of claims 1 to 5 or 23 characterised in that the electronic module (2) which projects beyond the connection plates remote from the mounting rail (1) is matching with its casing dimensions to the installation dimensions in small-scale distribution installations.

24. A modular control installation according to one of the preceding claims characterised in that a plug-in termination plate (57) with terminal resistors (58) can be provided at the end of the internal bus conductor remote from the field bus end, which termination plate can preferably be in the form of a plug-in shoe with a board (62) which is arranged on the internal bus conductor board (13) and which carries the terminal resistors (58).

25. A modular control installation according to one of the preceding claims characterised in that each electronic module (2) includes at least one respective plug-in and releasable plug connection (11) for connection to the signal conductors of the initiators, actuators. field devices or the like and to the internal bus conductor (13) and functional circuit boards (40) connecting said plug connections.

26. A modular control installation according to one of claims 1 to 5 or 13 characterised in that when connecting digital initiators to the connection block (3) only the signal line can be connected, wherein the supply for said initiators with required electrical potentials is preferably effected outside the connection block (3).

27. A modular control installation according to one of claims 1 to 5 or 13 characterised in that when connecting active initiators/actuators/field devices there are always provided at least one respective device (6) for accommodating a distributor link and at least one respective signal conductor connection (8).

28. A modular control installation according to one of claims 1 to 5 or 7 characterised in that the electronic module (2) has a variably coded casing.

29. A modular control installation according to one of claims 1 to 5 or 25 characterised in that when the electronic module (2) is removed all remaining connection blocks (3) arranged on a mounting rail (1) are fully operational.

30. A modular control installation according to one of claims 1 to 5 or 13 characterised in that the conductor connection to the connection blocks (3) is effected from the side remote from the mounting rail (1) and that the electronic module (2) is removable without releasing the wiring.

31. A modular control installation according to one of the preceding claims characterised in that disconnect plugs can be provided for testing the electronic module (2) and the signal states of the connected signal conductors.

32. A modular control installation according to one of the preceding claims characterised in that signal adaptation for connection of the internal bus conductor (13) to a superior field bus is effected in a field bus connection module (4) arranged on the mounting rail (1).

33. A modular control installation according to one of the preceding claims characterised in that the electrical connection of the internal bus conductor (13) to a superior field bus is effected by means of direct wiring to the field bus connection module (4) arranged at the beginning of the mounting rail (4).

34. A modular control installation according to claims 1 to 5 or 14 characterised in that non-cross-connecting elements (61) can be plugged into the devices (6) for acccomodating distributor links. by means of which elements (61) different electrical potentials which are fed into a distributor link can be electrically separated from each other.

## Revendications

1. Installation de commande modulaire pour systèmes électroniques de commande et d'automatisation de bâtiments, comportant
- au moins deux blocs de jonction (3), à serrer et à joindre les uns aux autres sur un rail de support (1) commun, constitués chacun d'un nombre de disques de jonction (24, 25, 26, 27) à joindre les uns aux autres et de bornes d'alimentation et/ou de bornes de ligne de signaux, disposées à l'intérieur, pour des initiateurs, des actionneurs, des appareils de champ ou similaires,
- des dispositifs de distribution de potentiels électriques à l'intérieur de ce même bloc de jonction (3),
- une ligne de bus interne (13) pour la liaison de tous les blocs de jonction (3) disposés sur le rail de support (1),
- au moins un module électronique (2) pour le traitement des signaux lors de la liaison d'initiateurs, actionneurs, appareils de champ ou similaires à raccorder aux lignes de signaux.
- un module de jonction (4) pour la connexion de la ligne de bus interne (13) à un bus de champ correspondant,
caractérisée en ce que
- à l'intérieur de chaque bloc de jonction (3) sont disposés au moins un disque conducteur de protection (25), au moins un disque d'alimentation (26) et au moins un disque de ligne d'alimentation/ligne de signaux (27) dont les zones de fonctionnement pré-établies présentent un assemblage structuré sous forme de succession ferme s'étendant dans l'espace,
- le disque conducteur de protection (25) présente des zones pour le prélèvement d'un potentiel du conducteur de protection, à partir du rail de support (1) et pour la transmission du potentiel du conducteur de protection au module électronique (2),
- le disque d'alimentation (26) présente des zones pour l'alimentation du module électronique (2) et pour l'alimentation de barres de distribution montées en série à partir d'éléments de jonction (7), avec au moins un potentiel de tension et
- le disque de ligne d'alimentation/ligne de signaux (27) présente des zones pour la distribution transversale de potentiels électriques à d'autres disques de jonction de ce même bloc de jonction, auxquels des initiateurs, actionneurs, appareils de champ ou similaires correspondants peuvent être raccordés, ainsi que des zones pour la connexion de lignes de signaux des initiateurs, actionneurs, appareils de champ ou similaires correspondants, sur chacun des disques de ligne d'alimentation/ligne de signaux, les zones pour la distribution transversale de potentiels électriques et pour la connexion de lignes de signaux, étant prévues des deux côtés transversalement au rail de support (1), la disposition dans l'espace des disques de jonction (24, 25, 26, 27) s'effectuant dans le même ordre dans tous les blocs de jonction (3).

2. Installation de commande modulaire selon la revendication 1, caractérisée en ce que les disques de jonction présentent en outre une zone pour la disposition non permanente du module électronique (2) au-dessus du rail de support (1) et au-dessus de la ligne de bus interne (13) disposée au milieu du bloc de jonction et sous le module électronique, avec laquelle le module électronique peut être relié électriquement par enfichage.

3. Installation de commande modulaire selon la revendication 1 ou 2, caractérisée en ce que les zones pour la distribution transversale de potentiels électriques et pour la connexion à la ligne de signaux est identique sur le plan fonctionnel des deux côtés du rail de support.

4. Installation de commande modulaire selon la revendication 1, 2 ou 3 caractérisée en ce qu'à la première zone pour la connexion de lignes de signaux (8), des initiateurs, actionneurs, appareils de champ ou similaires correspondants peuvent aussi être connectés leurs lignes d'alimentation.

5. Installation de commande modulaire selon l'une des revendications précédentes, caractérisée en ce que le disque conducteur de protection présente en outre des zones pour la transmission du potentiel du conducteur de protection au moins à l'un des éléments de jonction (7).

6. Installation de commande modulaire selon la revendication 1 ou 2, caractérisée en ce qu'à l'intérieur de chaque bloc de jonction (3) sont disposés les disques de jonction (24 à 27) dans cet ordre: un disque conducteur de protection (25), au moins un disque d'alimentation (26), à la suite du disque d'alimentation au moins un disque de ligne d'alimentation/ligne de signaux (27) et éventuellement un disque de pied d'encliquetage (24).

7. Installation de commande modulaire selon l'une des revendications 1 à 6, caractérisée en ce que les disques de jonction présentent, transversalement au rail de support, une construction symétrique par rapport au module électronique.

8. Installation de commande modulaire selon l'une des revendications 1 à 7, caractérisée en ce que le disque conducteur de protection (25) présente un branchement mécanique et électrique avec le rail de support (1) et une connexion à fiches (11) avec le module électronique (2).

9. Installation de commande modulaire selon l'une des revendications 1 à 8, caractérisée en ce que le disque conducteur de protection (23) avec la distribution de potentiel peut être relié à d'autres disques de jonction (24, 26, 27) du même bloc de jonction (3).

10. Installation de commande modulaire selon l'une des revendications 1 à 7, caractérisée en ce que le disque d'alimentation (26) peut être relié à la distribution de potentiel à d'autres disques de jonction (24 à 27) du même bloc de jonction (3) ainsi qu'au module électronique (2).

11. Installation de commande modulaire selon l'une des revendications 1 à 7 ou 10, caractérisée en ce que dans le cas d'une forme de construction avec chacune au moins un dispositif (6) destiné à recevoir des barres de distribution des deux côtés du module électronique (2), l'alimentation du potentiel électrique correspondant s'effectue pour chaque côté, dans au moins un disque d'alimentation (26) disposé en tant que deuxième disque de jonction extérieur des deux côtés du bloc de jonction (3), l'alimentation s'effectuant de préférence seulement sur un côté du module électronique (2) et la zone opposée du disque d'alimentation (26) pouvant être utilisée pour la connexion d'initiateurs, d'actionneurs, d'appareils de champ ou similaires.

12. Installation de commande modulaire selon l'une des revendications 1 à 6, 10 ou 11 caractérisée en ce que sur le disque d'alimentation (26) il n'existe qu'une liaison avec le module électronique (2).

13. Installation de commande modulaire selon l'une des revendications 1 à 7, caractérisée en ce que le disque de ligne d'alimentation/ligne de signaux (27) est constitué, si nécessaire, de dispositifs (6) destinés à recevoir des barres de distribution, des bornes de ligne de signaux (8) et des connexion à enfichage pour le module électronique (11).

14. Installation de commande modulaire selon l'une des revendications 1 à 5 ou 13, caractérisée en ce que chaque dispositif (6) présente, pour recevoir des barres de distribution, des contours de fixation pour des éléments de jonction (7), également pour la distribution transversale, qui peuvent être enfichés et encliquetés dans les barres de distribution et qui peuvent de préférence être colorés.

15. Installation de commande modulaire selon l'une des revendications 1 à 5 ou 13, caractérisée en ce que dans le cas d'une forme de construction sans barres de distribution sur un côté, les bornes de lignes de signaux peuvent être reliées par des peignes de distribution transversale à une borne du disque d'alimentation (26), tandis que sur l'autre côté de la ligne de signaux, s'effectue le retour des signaux de chaque initiateur, actionneur, appareil de champ ou similaire correspondant.

16. Installation de commande modulaire selon l'une des revendications 1 à 7, caractérisée en ce que sur chacun des deux côtés du module électronique (2), à chaque disque de ligne d'alimentation/ligne de signaux peut être connecté un initiateur, actionneur, appareil de champ ou similaire.

17. Installation de commande modulaire selon l'une des revendications précédentes, caractérisée en ce que chaque bloc de jonction (3) présente sur les deux côtés de passage du rail de support (1), des disques de jonction (24, 25) qui présentent des pieds d'encliquetage (9) affectés au rail de support (1) pour le serrage mécanique sur ce rail de support (1) et/ou la liaison électrique avec ce rail de support (1).

18. Installation de commande modulaire selon l'une des revendications 1 à 5 ou 17, caractérisée en ce qu'un disque de pied d'encliquetage (24) présente exclusivement une jonction mécanique avec le rail de support (1).

19. Installation de commande modulaire selon l'une des revendications précédentes, caractérisée en ce que les bornes d'initiateurs, actionneurs, appareils de champ ou similaires de même type peuvent être réunies au besoin dans ces blocs de jonction (3) de disques de jonction (27) de même type.

20. Installation de commande modulaire selon l'une des revendications précédentes, caractérisée en ce que les bornes d'initiateurs, actionneurs, appareils de champ ou similaires différents peuvent au besoin être réunies dans des blocs de jonction (3) de disques de jonction (27) différents.

21. Installation de commande modulaire selon l'une des revendications 1 à 5, caractérisée en ce que la ligne de bus interne (13) est constituée de pièces de rail de bus, qui peuvent être reliées de manière non permanente et électro-mécaniquement aux pièces de ligne de bus voisines, par des coulisseaux de séparation (14) qui peuvent coulisser et s'encliqueter.

22. Installation de commande modulaire selon l'une des revendications précédentes, caractérisée en ce que la zone (13) de la ligne de bus sur le côté tourné à l'opposé du rail de support (1) est dissimulée par le module électronique (2) enfiché et les pièces de rail de bus à relier entre elles ne sont accessibles qu'après enlèvement du module électronique (2).

23. Installation de commande modulaire selon l'une des revendications 1 à 5 ou 22, caractérisée en ce que le module électronique (2) qui dépasse des disques de jonction à l'opposé du rail de support (1) est adapté par les dimensions de son boîtier aux cotes de montage dans de petites installation de distribution.

24. Installation de commande modulaire selon l'une des revendications précédentes, caractérisée en ce qu'à l'extrémité de la ligne de bus interne (13), tournée à l'opposé de l'extrémité côté bus de champ, on peut prévoir un disque de fermeture (57) enfichable avec des résistances de fermeture (58), qui peut être réalisé de préférence sous la forme d'un patin d'enfichage avec une platine (62) qui est disposée sur la platine interne (13) de la ligne de bus et qui porte les résistances de fermeture (58),

25. Installation de commande modulaire selon l'une des revendications précédentes, caractérisée en ce que chaque module électronique (2) contient au moins une connexion à fiches (11) enfichable et séparable pour la liaison avec les lignes de signaux des initiateurs, actionneurs, appareils de champ ou similaires et avec la ligne de bus interne (13) ainsi que des plaques de lignes de fonction (40) reliant ces connexion à fiches.

26. Installation de commande modulaire selon l'une des revendications 1 à 5 ou 13, caractérisée en ce que dans le cas d'une connexion d'initiateurs numériques au bloc de jonction (3), seule la ligne de signaux peut être connectée, l'alimentation des ces initiateurs s'effectuant avec des potentiels électriques nécessaires, de préférence à l'extérieur du bloc de jonction (3).

27. , Installation de commande modulaire selon l'une des revendications 1 à 5 ou 13, caractérisée en ce que dans le cas de la connexion d'initiateurs/actionneurs/appareils de champ actifs, au moins un dispositif (6) est toujours prévu pour recevoir des barres de distribution et au moins une borne de lignes de signaux (8).

28. Installation de commande modulaire selon l'une des revendications 1 à 5 ou 7, caractérisée en ce que le module électronique (2) présente un boîtier codé de manière variable.

29. Installation de commande modulaire selon l'une des revendications 1 à 5 ou 25, caractérisée en ce que lorsque le module électronique (2) est enlevé, tous les blocs de jonction (3) restants qui sont disposés sur un rail de support (1) sont pleinement en état de fonctionner.

30. Installation de commande modulaire selon l'une des revendications 1 à 5 ou 13, caractérisée en ce que la connexion de lignes aux blocs de jonction (3) s'effectue à partir du côté tourné à l'opposé du rail de support (1) et en ce que le module électronique (2) peut être enlevé sans suppression du câblage.

31. Installation de commande modulaire selon l'une des revendications précédentes, caractérisée en ce que pour vérifier le module électronique (2) ainsi que les états des signaux des lignes de signaux connectées, on peut prévoir des déconnecteurs.

32. Installation de commande modulaire selon l'une des revendications précédentes, caractérisée en ce que l'adaptation des signaux pour relier la ligne de bus interne (13) à un bus de champ supérieur s'effectue dans un module de jonction de bus de champ (4) disposé sur le rail de support (1).

33. Installation de commande modulaire selon l'une des revendications précédentes, caractérisée en ce que la liaison électrique de la ligne de bus interne (13) à un bus de champ supérieur s'effectue au moyen d'un câblage direct au module de jonction de bus de champ disposé au début du rail de support (1).

34. Installation de commande modulaire selon l'une des revendications 1 à 5 ou 14, caractérisée en ce que dans les dispositifs (6) destinés à recevoir des barres de distribution on peut enficher des éléments (61) qui n'assurent pas une liaison transversale, par lesquels des potentiels électriques différents alimentés dans un barre de distribution, peuvent être électriquement séparés les uns des autres.
